(19) Europäisches Patentamt / European Patent Office / Office européen des brevets

(11) **EP 4 160 313 A1**

(12) **EUROPEAN PATENT APPLICATION**

(43) Date of publication:
**05.04.2023 Bulletin 2023/14**

(21) Application number: **21200214.1**

(22) Date of filing: **30.09.2021**

(51) International Patent Classification (IPC):
**G03F 7/20** *(2006.01)*   **G03F 7/00** *(2006.01)*
**B33Y 10/00** *(2015.01)*

(52) Cooperative Patent Classification (CPC):
**G03F 7/2012; B29C 64/135; B33Y 10/00;**
**B33Y 80/00; G03F 7/0037; G03F 7/2053**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicants:
• **Max-Planck-Gesellschaft zur Förderung der Wissenschaften e.V.**
  **80539 München (DE)**
• **Karlsruher Institut für Technologie**
  **76131 Karlsruhe (DE)**

(72) Inventors:
• **Göpfrich, Kerstin**
  **71665 Vaihingen/Enz (DE)**

• **Abele, Tobias**
  **69115 Heidelberg (DE)**
• **Jahnke, Kevin**
  **69121 Heidelberg (DE)**
• **Walther, Tobias**
  **69124 Heidelberg (DE)**
• **Wegener, Martin**
  **76227 Karlsruhe (DE)**
• **Messer, Tobias**
  **76139 Karlsruhe (DE)**
• **Hippler, marc**
  **76199 Karlsruhe (DE)**

(74) Representative: **Manitz Finsterwald**
**Patent- und Rechtsanwaltspartnerschaft mbB**
**Martin-Greif-Strasse 1**
**80336 München (DE)**

(54) **METHOD FOR NON-INVASIVE PRODUCTION OF DEFINED STRUCTURES INSIDE COMPARTEMENTS AND COMPARTMENT**

(57) The present invention relates to a method for non-invasive production of defined structures (1) inside compartments (2), wherein the method comprises the steps of: providing a compartment having an inside filled with a liquid, comprising a photoresist, and applying light (6) to the inside of the compartment including the photoresist, wherein the light has a focal point (7) inside the compartment and initiates a chemical reaction of the photoresist at the focal point, creating a defined structure. Further, the present invention relates to a compartment, having an inside, surrounded by a compartment wall, wherein the compartment comprises a defined structure obtainable by a method according to any one of the preceding claims.

**Fig. 1**

**Description**

The present invention concerns a method for non-invasive production of defined structures inside compartments and to a compartment comprising such a structure.

Bottom-up synthetic biology is a growing field at the interface of biology and materials science with the visionary aim to construct a functional cell from molecular building blocks [1, 2, 3]. Towards this goal, several techniques have become available to assemble cell-sized giant unilamellar lipid vesicles (GUVs) as mimics of cellular compartments [4, 5, 6, 7, 8, 9]. Versatile synthetic and natural components have been reconstituted inside GUVs to achieve important functions of cells, such as compartment replication [10], energy generation [11, 12] or transmembrane trafficking [6, 13, 14]. However, the highly controlled spatio-temporal organization that characterizes living cells remains hitherto unachieved in today's synthetic counterparts.

Introducing space-filling structures into already formed compartments appears to be in contradiction with the barrier defining the compartment volume. Hence, the internal organization of synthetic cells typically relies on self-assembly, which limits the complexity of the achievable end result. Especially when it comes to the recombination of several functional modules, self-assembly can be impaired due to undesired interactions or incompatible environmental requirements [2, 15]. Early attempts have been made to address this shortcoming by the sequential addition of components by injection through the lipid membrane [5, 16] or vesicle fusion [17, 18, 19, 20]. While such strategies can increase the achievable complexity, it also disrupts the membrane and changes the compartment volume. Alternatively, a lipid vesicle can be formed around a preformed element, which has led to promising results [21, 4, 22]. However, this "inside-out" assembly strategy for synthetic cells neglects the role of confinement for the assembly process itself. Therefore, strategies for the non-destructive alteration of internal organization of the compartment and the addition of large structures inside compartments are highly desirable.

Toward this end, light-triggered actuation of chemical reactions [23, 24, 25, 26] and dynamic mechanical response [27, 28] opens up exciting directions. Similarly, the light-triggered polymerization of a space-filling hydrogel was realized inside cells [29] and lipid vesicles [30]. Nevertheless, strategies for the assembly of well-defined arbitrary architectures inside preformed compartments are missing in bottom-up synthetic biology, and, more broadly, in 3D manufacturing.

The present invention solves the above problems of manufacturing structures inside of existing compartments.

Specifically, the present invention relates to a method for non-invasive production of defined structures inside compartments wherein the method comprises the steps of: (a) providing a compartment having an inside filled with a liquid, comprising a photoresist and (b) applying a light to the inside of the compartment including the photoresist, wherein the light has a focal point inside the compartment and initiates a chemical reaction of the photoresist at the focal point.

The light with the focal point inside the compartment initiates the chemical reaction of the photoresist at a confined spatial region of the compartment's inner volume. At the focal point the photon density is the highest. This allows for spatially controlling the chemical reaction of the photoresist inside the compartment. This kind of control over the chemical reaction of the photoresist enables the controlled generation of freely chosen structures, without destroying the compartment.

The term "non-invasive" as used herein, means that the compartment remains intact, even after producing the structure, i.e. the compartment does not lose its integrity.

The compartment is a spatially confined area and is not limited to a specific type or may be a vesicle, a droplet, a coacervate, a synthetic cell, a natural cell, an organelle or any compartment. The compartment wall should allow for light propagation of the wavelength of interest, i.e. the wavelength for initiating photopolymerization. The compartmente wall may be a membrane, such as a lipid membrane. In accordance with the present invention, the compartment is preferably a giant unilamellar lipid vesicle, such as those mentioned above in the introductory portion. Preferably, the compartment has a compartment wall defining the inside of the compartment and an outside thereof, wherein the compartment wall can have a surfactant-stabilized fluid interface with its environment.

In accordance with the present invention it is preferred that the compartment provided in step (A) comprises at least one surfactant. The surfactant is not particularly limited and may be a polymeric surfactant or a lipid that is capable of stabilizing the interface of the compartment to the surrounding environment.

Good results are particularly obtained, if the surfactant is a block copolymer comprising a lipophilic or a hydrophobic block and a hydrophilic block. The lipophilic or hydrophobic block may be, but is not restricted to members, e.g. selected from the group consisting of perfluorinated polymers, such as perfluorinated polyethers, polystyrene or poly(olefin oxides), such as poly(propylene oxide), whereas the hydrophilic block may be selected e.g. from polyether glycols, polyetheramine, polyacrylate acid, polymethylacrylate acid or poly[poly(ethylene glycol) methyl ether methacrylate].

Likewise, good results are obtained, if the compartment is stabilized by a shell made of a triblock copolymer comprising two hydrophobic perfluorinated polymer end blocks and therebetween a hydrophilic polyether glycol block, wherein the triblock copolymer is folded so that the hydrophobic perfluorinated polymer blocks are arranged at the outer side and that the hydrophilic polyether glycol block is arranged at the inner side of the polymer shell. Examples for the lipophilic or hydrophobic blocks and the hydrophilic blocks are the same as those mentioned above.

Preferably, the perfluorinated polymer block is a perfluorinated polyether block (PFPE) and more preferably a perfluorinated polyether block having a weight average molecular weight of 1,000 to 10,000 g/mol. Likewise preferably, the polyether glycol (PEG) and polyetheramine (JEFFAMINE) blocks have preferably a weight average molecular weight of 100 to 10,000 g/mol. More specifically, suitable examples for the respective copolymers are PFPE-carboxylic acid (Krytox, MW 2500 or 7000 g/mol) and suitable examples for the respective diblock copolymers are PFPE(7000 g/mol)-PEG(1400 g/mol), PFPE(7000 g/mol)- PEG(600 g/mol), PFPE(2500 g/mol)- PEG(600 g/mol), PFPE(4000 g/mol)-PEG(600 g/mol), PFPE(4000 g/mol)- PEG(1400 g/mol), PFPE(2000 g/mol)- PEG(600 g/mol), PFPE(7000 g/mol)- JEFFAMINE(600 g/mol), PFPE(7000 g/mol)- JEFFAMINE (900 g/mol), PFPE(2500 g/mol)- JEFFAMINE(600 g/mol), PFPE(2500 g/mol)- JEFFAMINE(900 g/mol), PFPE(4000 g/mol)- JEFFAMINE(900 g/mol), PFPE(2500 g/mol)-JEFFAMINE(600 g/mol), PFPE(2000 g/mol)- JEFFAMINE (600 g/mol), PFPE(2000 g/mol)- JEFFAMINE (900 g/mol) and suitable examples for the respective triblock copolymers are PFPE(7000 g/mol)-PEG(1400 g/mol)-PFPE(7000 g/mol), PFPE(7000 g/mol)-PEG(600 g/mol)-PFPE(7000 g/mol), PFPE(4000 g/mol)-PEG(1400 g/mol)- PFPE(4000 g/mol) PFPE(2500 g/mol)- PEG(600 g/mol)-PFPE(2500 g/mol), PFPE(2000 g/mol)- PEG(600 g/mol)-PFPE(2000 g/mol), PFPE(7000 g/mol)- JEFFAMINE(900 g/mol)-PFPE(7000 g/mol) PFPE(7000 g/mol)-JEFFAMINE(600 g/mol)-PFPE(7000 g/mol), PFPE(4000 g/mol)- JEFFAMINE(900 g/mol)-PFPE(4000 g/mol), PFPE(4000 g/mol)- JEFFAMINE(600 g/mol)-PFPE(4000 g/mol), PFPE(2500 g/mol)- JEFFAMINE(900 g/mol)-PFPE(2500 g/mol), PFPE(2500 g/mol)- JEFFAMINE(600 g/mol)-PFPE(2500 g/mol), PFPE(2000 g/mol)- JEFFAMINE(900 g/mol)-PFPE(2000 g/mol) and PFPE(2000 g/mol)- JEFFAMINE(600 g/mol)-PFPE(2000 g/mol). The molecular weight is determined with gel permeation chromatography using a polystyrene standard.

It is further preferred that at least one of the hydrophobic blocks of the surfactant is fluorinated. A stable compartment, e.g. a droplet, can be obtained, when the surfactant is a block copolymer comprising one block having a polyethylene glycol segment and comprising another block which is fluorinated. According to a particularly preferred embodiment of the present invention, the block copolymer is a diblock copolymer or a triblock copolymer. Particularly preferred surfactants are of Perflouro-polyether-polyethylene glycol (PFPE-PEG) block-copolymer fluorosurfactants, for example PFPE-PEG diblock-copolymer surfactant or a PFPE-PEG-PFPE triblock-copolymer surfactant.

The present invention is not particularly limited concerning the chemical nature of the at least one lipid that may be contained in the inner space and at the fluid interface of the compartment, as long as the lipid is able to form a lipid bilayer. Good results are in particular achieved with phospholipids and in particular with a lipid being selected from the group consisting of phosphocholine, phosphocholine derivatives, phosphoethanolamine, phosphoethanolamine derivatives, phosphatidylcholine, phosphatidylcholine derivatives, phosphatidylglycerol, phosphatidylglycerol derivatives and arbitrary combinations of two or more of the aforementioned lipids. Specific suitable examples for lipids are those selected from the group consisting of 1,2-dioleoyl-sn-glycero-3-phosphocholine (DOPC), 1,2-dioleoyl-sn-glyc-ero-3-phosphoethanolamine (DOPE), 1,2-dioleoyl-sn-glycero-3-phospho-L-serine (DOPS), 1,2-dioleoyl-sn-glycero-3-[(N-(5-amino-1 -carboxypentyl)iminodiacetic acid) succinyl] (DGS-NTA), 1,2-dioleoyl-sn-glycero-3-phosphoethanolamine-N-(lissamine rhodamine B sulfonyl) (RhB DOPE), 1-palmitoyl-2-hydroxy-sn-glycero-3-phosphate, L-$\alpha$-phosphatidylcho-line, L-$\alpha$-phosphatidylglycerol, cholesterol and arbitrary combinations of two or more of the aforementioned lipids.

Shape and size of the compartment are not limited. The present invention can be realized on differently shaped and sized compartments. Nevertheless, in view of easiness of production, the compartment has an essentially round diameter. Further, in view of the needs of synthetic biology, it is preferable that the compartment as provided in step (a) of the method according to the present invention has the size of a cell. More specifically, the diameter of the preferably round compartment is preferably in the range of 1 $\mu$m to 10.000 $\mu$m, preferably 3 $\mu$m to 1000 $\mu$m, more preferably 5 $\mu$m to 500 $\mu$m, even more preferably 10 $\mu$m to 200 $\mu$m. As used herein, the term "diameter of the compartment" refers to an equivalent spherical diameter. In case of a round compartment, it is the outer diameter of the compartment. The diameter can be determined microscopically.

In accordance with the present invention, the compartments are preferably giant unilamellar vesicles (which are abbreviated as GUV) or giant multilamellar vesicles. Giant unilamellar and multilamellar vesicles are usually spherical with a diameter of typically 1 to 1,000 $\mu$m.

The liquid in the compartment provided in step (a) of the present invention is not particularly limited. It is preferably chosen to be able to dissolve non-polymerized components of the photoresist. According to a preferred embodiment of the present invention, the liquid inside the compartment is an aqueous liquid, i.e. it contains water.

The compartment in step (a) can be provided by any means known in the art. Preferably the compartment is provided by electroformation, swelling, inverted emulsion techniques, vortexing, microfluidic techniques or the like. These techniques provide the compartment filled with liquid.

Electroformation is a method, which relies on applying a low voltage, typically alternating electric field during hydration of dried lipid films in aqueous solution. More specifically, in one known variant of this technique giant unilamellar vesicles are formed in channels sandwiched between glass slides coated with indium tin oxide electrodes by applying an alternative current. In contrast to this, microfluidic phase transfer methods comprise that in a circuit lipid-stabilized water-in-oil droplets, which are generated by flow focusing at low capillary number, are presented to a parallel extravesicular aqueous flow at high capillary number. The droplets are physically transferred through the lipid-stabilized oil/water interface upon reaching a micforabricated post, collecting a second outer coat of lipids to complete the vesicle bilayer.

As alternative compartments to protocells in form of giant unilamellar vesicles polymersomes are known, which are made from amphiphilic block copolymers. They enclose and are typically surrounded by an aqueous solution. Some polymersomes can be engineered with transmembrane proteins or synthetic channel molecules that enable certain chemicals to pass the polymer membrane.

The photoresist may be incorporated already at the time of forming the compartment, e.g. by microfluidic encapsulation, or at a later stage. The photoresist can be injected into an existing compartment, by using an injection, which is preferably a pico-injector. Further, it is possible to incorporate the photoresist by diffusion into the compartment across the membrane itself or across pores in the membrane. It is also possible to use electroporation techniques for incorporating the photoresist into the compartment. Also a combination of these techniques may be used.

In addition to the photoresist, further compounds may be included in the compartment provided in step (a) of the present invention. Such further compounds can be porogens, which influence the porosity of a structure produced in step (b). An Example of such porogens are carbohydrates, such as sugars or oligomeric carbohydrates, and salts, such as alkali and earth alkali halogenides. Preferably, the porogen is soluble in water.

It is preferred that the light applied in step (b) of the method of the present invention, is a laser beam, more preferably a focused laser beam, having its focal point inside the compartment. The focused laser beam provides a high photon density at the focal point, allowing high spatial control over the polymerization reaction. Such spatial control makes it possible to provide structures with a high spatial resolution. This makes it possible to generate complex structures, such as 2-dimensional and 3-dimensional grids or even pores and/or porous structure. Particularly good results are obtainable by using pulsed laser, preferably a femtosecond pulsed laser.

The wavelength of the light is not particularly limited and can be chosen by the skilled person based on the type of photoresist, in particular of the initiator, and the type of compartment or compartment wall. According to a preferred embodiment, the wavelength of the light is around the wavelength of an absorption maximum of the initiator or around double the wavelength of the absorption maximum of the initiator. By applying light having around double the wavelength, two-photon absorption can be utilized allowing particularly high spatial resolution for preparing the defined structures inside the compartment.

Without being bound to a theory, it is assumed that the high photon density, i.e. high light intensity, allows for kinetic control over the chemical reaction of the photoresist. Thereby, the reaction can be confined to a microscopic point inside the compartment. By moving the focal point, it is possible to shift the place of the reaction. This makes it possible to "write" the desired structure inside the compartment. In view of this, it is preferable to move during step (b) the focal point of the light inside the compartment. Moving the focal point means that the position of the focal point is moved relatively to the boundaries of the compartment, i.e. this can be achieved by either moving the focal point or by fixing the focal point and moving the compartment. In view of the easiness of set-up, it is preferable to move the focal point. For example, the method of the present invention can be carried out by using a confocal microscope, which allows spatial and temporal control over the focal point inside the compartment.

According to a particularly preferred embodiment, the compartment has a compartment wall, e.g. in the form of a membrane, defining an inside and an outside of the compartment. In this embodiment, the focal point is moved across the compartment wall. By moving the focal point across the compartment wall, it is possible to create a transmembrane structure, in particular a porous transmembrane structure. Thereby, transmembrane pores can be generated, which open up a passage for molecules to penetrate across the membrane. The focal point can be moved from the inside to the outside of the compartment wall or from the outside to the inside. In this embodiment, the photoresist can be present inside and outside the compartment. Most preferably, when moving the focal point across the compartment wall the photoresist is selected so that it is soluble in the liquid which is inside the compartment and also soluble in the liquid which is outside the compartment.

The photoresist can be a negative resist, which is hardened by the exposure to light. It is also possible that the photoresist is a positive resist, which is solubilized by the exposure to light. Negative resists and positive resists are well known to the skilled person and the present invention is not limited to specific types of negative or positive resists.

In accordance with the present invention, the photoresist is preferably a negative resist, including a monomer component and an initiator component, wherein the monomer has more than one polymerizable group.

The concentration of the monomer component in the liquid is preferably in the range of 1 mg/ml to 500 mg/ml, preferably in the range of 5 mg/ml to 400 mg/ml, more preferably in the range of 10 mg/l to 300 mg/ml, even more preferably in the range of 50 mg/ml to 150 mg/ml. It was found that the production of structures can be realized over a wide concentration range, even for relatively low concentrations. If the concentration of the monomer component is lower than indicated above, there is a risk that the defined structures lack stability or the printing of a structure inside the compartment may not be possible.

Also the concentration of the initiator component, preferably a photopolymerization initiator, can be varied over a broad range. The concentration of the initiator component in the liquid is preferably in the range of 0.5 mg/ml to 200 mg/ml, more preferably in the range of 1 mg/ml to 100 mg/ml, even more preferably in the range of 5 mg/ml to 50 mg/ml, even further more preferably in the range of 10 mg/ml to 30 mg/ml. With the concentration being in the range above, it is high enough to rapidly initiate the chemical reaction. For lower concentrations, printing a structure inside the compartment may not be possible. Further, the concentration is not too high. If the concentration of the initiator component is higher than indicated above, there is a risk that the chemical reaction is not only initiated at the focal point but also at other positions, where the light is not focused. In such a case, spatial resolution for producing the defined structures can be deteriorated and in some cases the compartment wall can be damaged.

A preferred example for a negative photoresist is one that includes a monomer component being capable of radical polymerization. Preferably the monomer component has more than one group derived from one of acrylic acid, acrylic acid esters, methacrylic acid, methacrylic acid esters, styrene, styrene derivatives, vinyl halides, e.g. vinyl chloride, vinyl esters, e.g. vinyl acetate, or acrylonitrile. A suitable and particularly preferred example is an acrylate based monomer component, such as poly(ethylene glycol) diacrylate (PEGDA) and a suitable photoinitiator.

The type of photoinitiator is not particularly limited and the skilled person can select one that is known in the art. Examples for suitable photopolymerization initiators are acetophenone-based compounds, benzophenone-based compounds, benzoin-based compounds, thioxanthone-based compounds, anthraquinone-based compounds, azo compounds and others. Preferably, the photoinitiator is water soluble. A particularly preferred example for a photoinitiator is Lithium phenyl-2,4,6-trimethylbenzoylphosphinate (LAP).

Further suitable photoresists are for example photoresists utilizing the polymerization of acidic polymers, such as alginate, alginate salts of monovalent ions, e.g. sodium alginate and so on, via photo-induced uncaging of caged divalent ions. Details for alginate polymerization are described by Juárez et al in Front. Bioeng. Bio-technol., http://dx.doi.org/10.3389/fbioe.2014.00026. Details for caged Mg ions are described in J. Org. Chem. 1988, 53, 1966.1969, https://doi.org/10.1021/jo00244a022 ),

Another suitable photoresist is one utilizing polymerization of proteins via photosensitizer, such as e.g. printing of protein BSA with photosensitizer rose, such as described by Bengal in Small 2020, 16, 1906259, https://doi.org/10.1002/smll.201906259.

A further exemplary photoresist that may be used in the method of the present invention is a photoresist based on light-triggered click chemistry, which may be based on 1,3-dipolar cycloadditions, Diels-Alder reactions or thiol-ene addition.

Detailed examples for such light triggered click reactions are known to the skilled person and described for example by Kumar and Lin in Chem. Rev. 2021, 121, 12, 6991-7031.

It is also possible that the photoresist is based on light triggered polymerization of polymerizable monomers, as demonstrated for example by Furutani et al. in Polymer International, Voume 68, Issue 1, pages 79-82, https://doi.org/10.1002/pi.5696, or monomer-initiator conjugates, such as DNA motifs with photocleavable spacer ends or light-induced heating causing caramelization of sugar.

The negative resist can be a photoresist based on radical polymerization, as described above. However, also other polymerization mechanisms are possible. For example, the negative resist may be a DNA based resist, such as the one described by Kasahara et al., in "Photolithographic shape control of DNA hydrogels by photo-activated self-assembly of DNA nanostructures", APL Bioengineering 4, 016109 (2020); https://doi.org/10.1063/1.5132929. Accordingly, the photoresist may include at least two different Y-shaped DNA nanostructures having sticky ends. The sticky ends of the different Y-shaped DNA nanostructures are not compatible to one another. Further, the resist includes a cross-linker DNA sequence, having sequences complementary to those of the sticky ends of the different Y-shaped DNA nanostructures. In an inactive state of the linker, the complementary DNA-sequences are non-accessible for the sticky ends of the Y-shaped DNA nanostructures. By irradiating with light, photocleavage within the inactive linker occurs and the sticky ends of the linker become accessible for the sticky ends of the Y-shaped DNA nanostructures and the photoresist hardens.

According to a preferred embodiment, the chemical reaction initiated in step (b) is a femtosecond two-photon polymerization.

As further described in the Examples, the photoresist can preferably be a positive resist that is DNA based. The DNA based positive resist can be based on Y-shaped DNA nanostructures, such as those utilized by Kasahara et al. and explained above for the negative DNA based resist. However, the linker compound has at least two complementary sequences linked to one another via a photocleavable group. The photocleavable group allows to cleave the linker after hardening of the resist. This makes it possible to erase previously hardened structures.

It is preferable that the photoinitiator is one that can be excited by two-photon absorption. Most preferably, in step (b) of the method of the present invention, the reaction is initiated by a two-photon absorption. Two-photon absorption requires the simultaneous absorption of two-photons to excite a molecule, i.e. the initiator compound or cross-linker compound of the photoresist, from a ground state to an excited state. Probability of a molecule to absorb two photons is proportional to the square of the light intensity. Therefore, by applying the two-photon absorption, it is possible to initiate the chemical reaction very precisely at the focal point of the light, i.e. at the point inside the compartment, where the light intensity is the highest. This allows for a very high spatial resolution.

The present invention further relates to a compartment, having an inside, surrounded by a compartment wall, wherein the compartment comprises a structure obtainable by the method of the present invention, as described above.

In accordance with the compartment of the present invention, the structure is a porous structure, preferably one extending through the compartment wall.

All details explained above or in the appended claims with regard to the method for non-invasive production of defined structures inside compartments apply mutatis mutandis also to the spatially confined compartment of the present invention.

Next the present invention will be described by reference to the drawings and examples. In the drawings, the following is shown:

Fig. 1:     Schematic illustration of 3D laser printing in a synthetic cell.

Fig. 2:     Micrographs of a polymerized structure in a surfactant-stabilized water-in-oil (w/o) droplet, wherein Fig. 2a shows a brightfield image, Fig. 2b shows a fluorescence image and Fig. 2c a composite image.

Fig. 3:     Experimental results of laser printing structures in GUVs, wherein Fig. 3a shows the diffusion of photoresist into and out of the GUV, Fig. 3b shows the increase of fluorescence intensity of a GUV as a function of time, Fig. 3c shows the membrane permeability of the photoresist and its components, Fig. 3d shows confocal images of printed 2D structures and Fig. 3e shows a reconstruction of confocal images of a 3D printed cube frame.

Fig. 4:     Plots showing size dependence of PEGDA and LAP influx into GUVs.

Fig. 5:     Plot for estimating the minimal printing concentration of PEGDA and LAP.

Fig. 6a-f:  Printing results inside GUVs with confocal microscope.

Fig. 7a-d:  Characterization of the GUV membrane and the printed hydrogel.

Fig. 8:     Results of FRAP experiments on polymerized photoresist before structure development (black dots) and after washing (yellow triangles) as a function of time.

Fig. 9:     AFM images of polymerized blocks of photoresist.

Fig. 10:    A plot of the surface roughness in terms of arithmetical mean deviation Ra as determined from AFM images of polymerized photoresist.

Fig. 11:    Sketch and result of 3D laser printing of a transmembrane-spanning pore across the GUV membrane, wherein Fig. 11a shows a schematic illustration of a printed porous structure extending throughout membrane of a GUV, Fig. 11b shows a plot of the Michelson contrast over time and representative bright-field optical images, Fig. 11c and 11d show representative confocal images of adjacent GUVs.

Fig. 12:    Michelson contrast as a function of time for (i) after printing a pore across the membrane and (ii) for a GUV without printing a pore across the membrane.

Fig. 13:    Schematic illustration of a DNA based negative photoresist (Fig. 13A) and of a DNA based positive photoresist (Fig. 13B).

Fig. 14:    Confocal microscopy images showing the printing and erasing of the DNA hydrogel in bulk.

Fig. 15:    Images showing the results of printing and erasing of DNA hydrogels in water-in-oil droplets.

Fig. 16:    Printing and erasing of DNA hydrogels inside giant unilamellar vesicles, wherein Fig. 16A shows printing, Fig. 16B show erasing, Fig. C shows adherence of the lipid membrane of the GUVs to the DNA hydrogel and Fig. 16D shows overlaid confocal fluorescence images showing the deformation of a large DNA hydrogel during GUV evacuation and

Fig. 17: subsequent shaping of the GUV following the erased structure of the DNA hydrogel in the same GUV. Results obtained from photocured DNA hydrogels, wherein Fig. 17A shows porosities of DNA hydrogels obtained from photoresists having different salt concentrations and Fig. 17B shows the result of a bleaching experiment , confirming the formation of a stable hydrogel.

Fig. 18: Experimental results obtained from printing and erasing of DNA hydrogel using a confocal microscope, wherein Fig. 18A shows an overlay of a confocal fluorescence ($\lambda_{ex}$ = 561nm, Cy3) and brightfield images depicting a DNA-hydrogel-containing water-in-oil droplet; Fig. 18B shows An intensity profile of the line depicted in Fig. 18A; Fig. 18C shows achieved minimum feature widths at different laser powers during printing of a DNA hydrogel; and Fig. 18C shows achieved minimum feature widths at different laser powers during erasing of a DNA hydrogel.

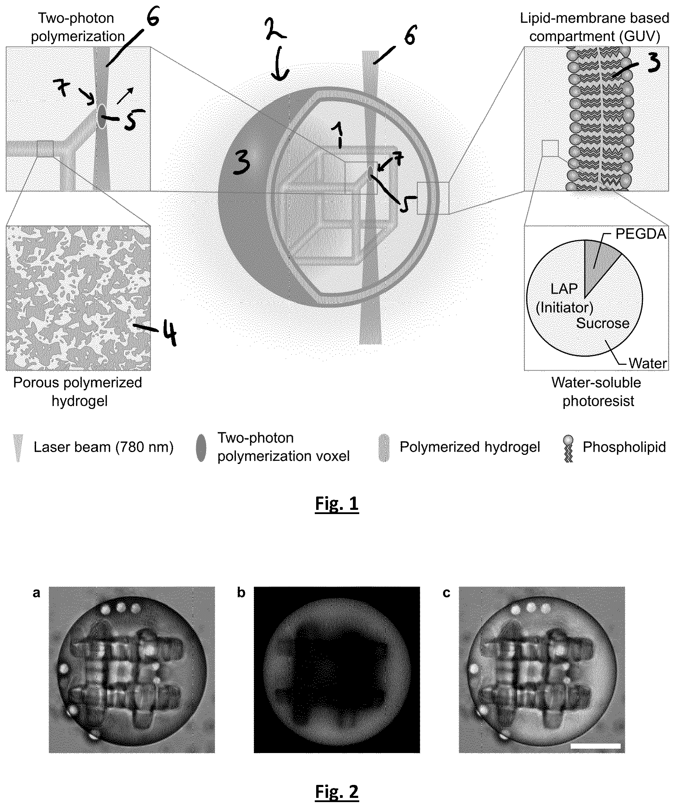

Fig. 1 is a schematic illustration of a 3D hydrogel cube frame as an exemplary object for a defined structure 1 that was written into a compartment 2 in the form of a preformed giant unilamellar lipid vesicle (GUV) by two-photon polymerization. GUVs are micron-sized lipid bilayer 3 enclosed compartments 2 often used as synthetic cell models. The nanoporous hydrogel cube frame 1 consists of polymerized PEGDA and was formed by local radical polymerization in presence of the photoinitiator LAP dissolved in aqueous sucrose-containing solution and is a porous structure 4. Polymerization is initiated by a laser beam 6 having its focal point 7 inside the compartment. At the focal point the light intensity is the highest so that the excitation of the polymerization initiator, such as LAP, can be limited to a small volume element, referred herein as voxel 5. Moving the focal point 7 of the laser beam 6, as illustrated by the arrow in the enlarged view on the upper left corner of Fig. 1, the position of the voxel 5, where polymerization occurs, is moved. In consequence, it is possible to "write" defined structures within the compartment 2, without destroying the compartment 2. Also the properties of the fluid interface of the compartment 2 are maintained.

Micrographs of polymerized structures 1 obtained from single-photon polymerization via laser scanning confocal microscope inside a compartment in the form of a surfactant-stabilized water-in-oil (w/o) droplet 2, using a 405 nm laser diode are shown in Fig. 2. In detail, Fig. 2a shows a brightfield image of a polymerized structure 1 inside a surfactant-stabilized water-in-oil droplet. Fig. 2b shows a corresponding fluorescence image of excited Atto 488 fluorophore (green, $\lambda_{ex}$=488 nm). Fig. 2c sows the composite image of brightfield channel and fluorescence channel. The scale bar indicated in Fig. 2c represents 50 $\mu$m.

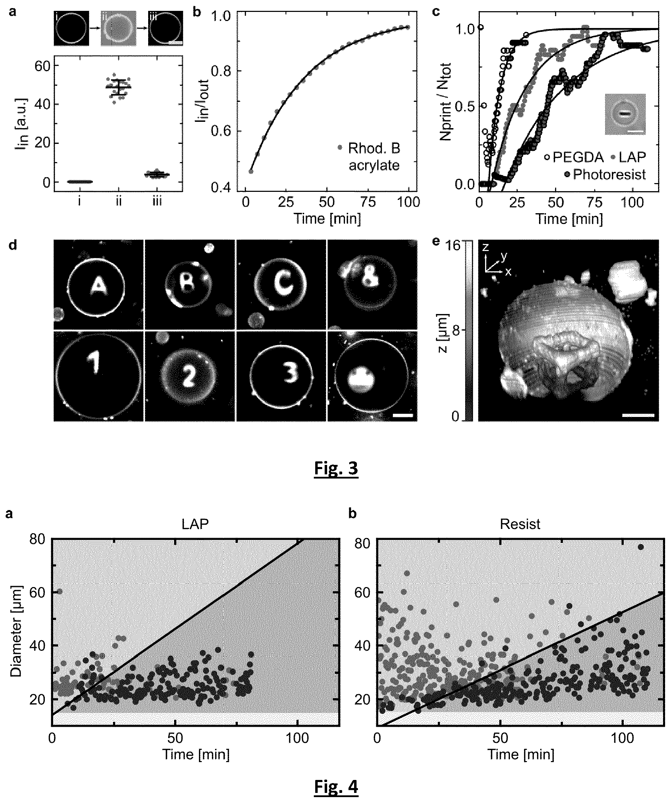

Fig. 3 sows experimental results of targeted laser printing of nearly arbitrary 2D and 3D hydrogel structures inside compartments 1 in the form of GUVs. Fig. 3a sows representative confocal images of a GUV (red, $\lambda_{ex}$ = 640 nm, visible in Fig. 3a i as a bright circular line) i) before mixing GUVs with photoresist, ii) 2 h after mixing GUVs with photoresist (yellow, fluorescent component: Rhodoamine B acrylat, $\lambda_{ex}$ = 561 nm, the background of Fig. 3a ii appears grey) and iii) 2 h after diluting the mixture of GUVs and photoresist from ii) in aqueous sucrose solution. The corresponding quantified fluorescence intensity inside the GUVs, $I_{in}$, is shown below (n=17-25, mean $\pm$ s.d.). The scale bar indicated in Fig. 3a iii) indicates 10 $\mu$m.

Fig. 3b is a plot showing the ratio of fluorescence intensity inside, $I_{in}$, and outside, $I_{out}$, of a GUV as a function of time. An exponential fit (black line) yielded a membrane permeability coefficient for the diffusion of Rhodamine B acrylate into the GUVs of P = 2.301 $\pm$ 0.016 nm s$^{-1}$.

Fig. 3c is a plot showing the membrane permeability of PEGDA, LAP and the complete photoresist consisting of the combination of PEGDA and LAP. The membrane permeability was determined by adding the respective components after incubation of the GUVs with the remaining components of the photoresist and quantifying the fraction of successful printing attempts, $N_{print}/N_{tot}$, inside the GUVs over time (n = 30 for each condition and time point). An exponential fit (black line) was used to determine the point in time of 50 % success rate. The micrograph image shown in the plot shows the GUV and the printed structure in the form of a rod. The scale bar in the micrograph image indicates a length of 10 $\mu$m.

Fig. 3d sows confocal images of printed 2D structures (yellow, $\lambda_{ex}$ = 561 nm) inside GUVs (red, $\lambda_{ex}$ = 640 nm, bright circular line in each micrograph of Fig. 3d). The scale bar indicated in the lower right corner of Fig. 3d represents 10 $\mu$m and applies to all confocal images of Fig. 3d.

A 3D surface reconstruction of confocal images of a 3D printed cube frame inside a 40 $\mu$m-sized GUV is shown in Fig. 3e. The scale bar indicated in Fig. 3e represents 10 $\mu$m.

Fig. 4 shows size dependence of PEGDA (Fig. 4b, "Resist" refers to PEGDA) and LAP (Fig. 4a) influx into GUVs. Unsuccessful (light grey) and successful (dark grey) printing attempts inside GUVs over time are presented. A linear classification algorithm was used to determine the printing success ratio inside GUVs during influx as a function of time and GUV diameter. As the permeability coefficient is inverse proportional to the GUV diameter, it takes longer until large GUVs are enriched with photoresist concentrations high enough for deterministic polymerization inside GUVs in comparison to small GUVs.

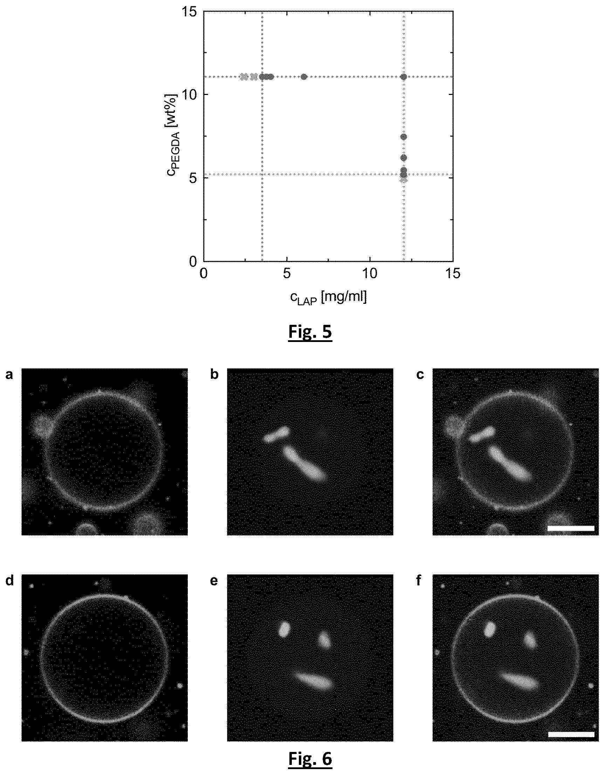

Fig. 5 shows a plot for estimating the minimal printing concentration of PEGDA and LAP. Based on the photoresist used in this work with 11.1 vol% PEGDA and 12 mg ml$^{-1}$ LAP, the concentration of one of the photoresist components was decreased until no rod structure could be printed anymore. Threshold concentrations were 3.5 mg ml$^{-1}$ LAP for 11.1 vol% PEGDA (upper dotted horizontal line and dotted vertical line at LAP concentration of 3.5 mg/ml) and 5.25 vol% PEGDA for 12 mg ml$^{-1}$ LAP (lower horizontal dotted line and horizontal dotted line at LAP concentration of 12 mg/ml). These values were used for the estimation of the LAP and PEGDA membrane permeability.

In Fig. 6 the printing results inside GUVs with confocal microscope are shown by confocal fluorescence images. Confocal fluorescence images of Fig. 6a a GUV labeled with Atto633-DOPE (red, $\lambda_{ex}$=640 nm, bright circular line), encapsulating Fig. 6b rotated polymerized structures (yellow, $\lambda_{ex}$=561 nm). Their shape is determined by the light cone typical for confocal microscopy. Fig. 6c shows the composite image of polymerized structures inside GUV. The scale bar in Fig. 6c represents 10 $\mu$m and applies also to Fig. 6a and 6b. Further, Fig. 6d shows a confocal fluorescence image of an Atto633-DOPE (red, $\lambda_{ex}$=640 nm, bright circular line) labeled GUV encapsulating the polymerized structures (shown in Fig. 6e in yellow, $\lambda_{ex}$=561 nm) assembled as a smiley. In Fig. 6f the composite fluorescence image of the polymerized smiley shaped structure inside the GUV is shown. The scale bar in Fig. 6f represents 10 $\mu$m and applies also to Fig. 6d and 6e.

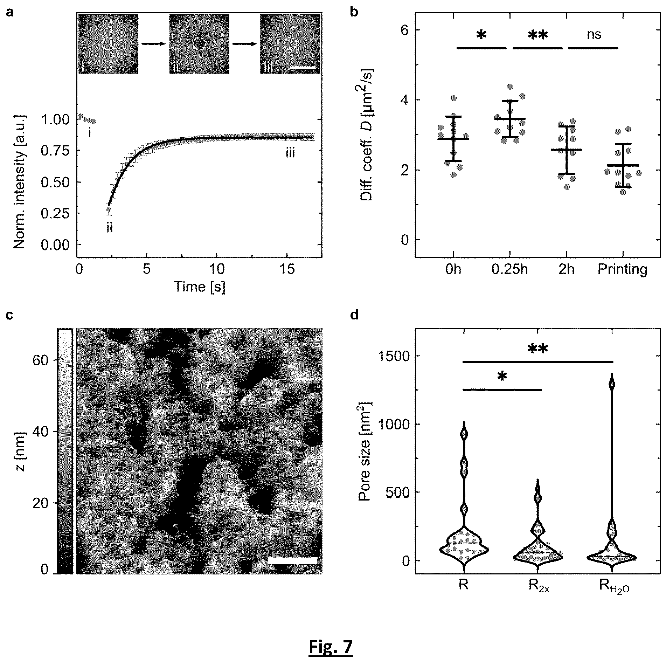

Images and plots shown in Fig. 7a to d show characteristics of the GUV membrane and the printed hydrogel.

Fig. 7a shows the results of FRAP experiments conducted on GUVs after printing. Confocal fluorescence images of the top plane of a GUV (red, $\lambda_{ex}$ = 640 nm, visible as light grey in Fig. 7a i, ii and iii) (i) before photobleaching of a circular area (inside the white dashed line), (ii) directly after photobleaching and (iii) after fluorescence recovery. The normalized mean intensity of the bleaching area is plotted over time. Error bars represent the standard deviation for n=12 GUVs after printing a hydrogel structure into their lumen. An exponential fit (black line) yields a lipid diffusion coefficient of D = 2.129 $\pm$ 0.610 $\mu$m s$^{-2}$, confirming that the membranes of the GUVs remain intact after printing. The scale bar indicated in Fig. 7a iii) represents 10 $\mu$m and applies also to the other micrographs shown in Fig. 7a.

Lipid diffusion coefficients determined by FRAP for GUVs before mixing with photoresist (0 h), 0.25 h after adding GUVs into photoresist (0.25 h), 2 h after adding GUVs into photoresist (2 h) and for GUVs in photoresist after printing a rod structure inside their lumen (n=10-12, mean $\pm$ s.d.) are indicated in the plot of Fig. 7b.

In Fig. 7c an AFM image of a polymerized block of the photoresist used for printing inside GUVs is shown, the scale bar represents 200 nm.

The pore size distributions as determined from AFM images for the polymerized photoresist (R) used for printing inside GUVs, the polymerized photoresist at doubled PEGDA and LAP concentration (R$_{2x}$), and polymerized photoresist in water without sucrose or glucose (R$_{H2O}$) are sown in Fig. 7d.

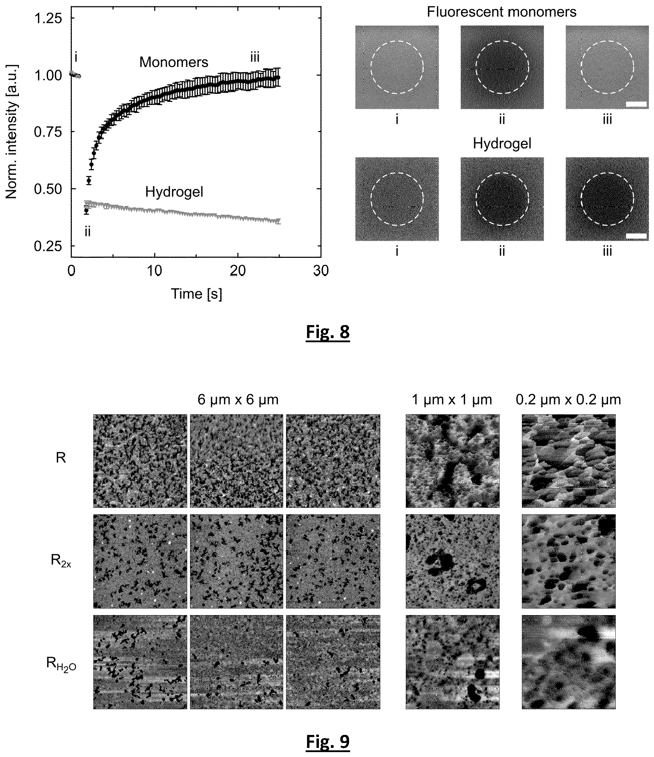

Results of FRAP experiments carried out on polymerized photoresist before structure development (black dots, "Monomers") and after washing (grey triangles, "Hydrogel") as a function of time are shown in the plot of Fig. 8. The normalized mean fluorescence intensity values are plotted as a function of time. Representative confocal images (yellow, $\lambda_{ex}$ = 561 nm, visible as light grey in Fig. 8) are also provided in Fig. 8. They show fluorescence intensity of the hydrogel i) before photo-bleaching, ii) immediately after photobleaching and iii) 22 s after bleaching a circular area (inside the white dashed line). Fluorescence recovery occurs due to photoresist diffusion inside the polymerized structure if no washing step is used, whereas no recovery for fluorescent monomers can be detected when the structure was developed, which is a proof of polymerization. The indicated scale bars represent 2 $\mu$m and apply to all of the confocal images.

AFM images shown in Fig. 9 were taken from polymerized blocks of photoresist (R) used for printing inside GVUs, of photoresist with twofold LAP and PEGDA concentration (R$_{2x}$) and of photoresist in water without any sucrose or glucose (R$_{H2O}$) at image sizes of 6 $\mu$m×6 $\mu$m, 1 $\mu$m×1 $\mu$m and 0.2 $\mu$m×0.2 $\mu$m.

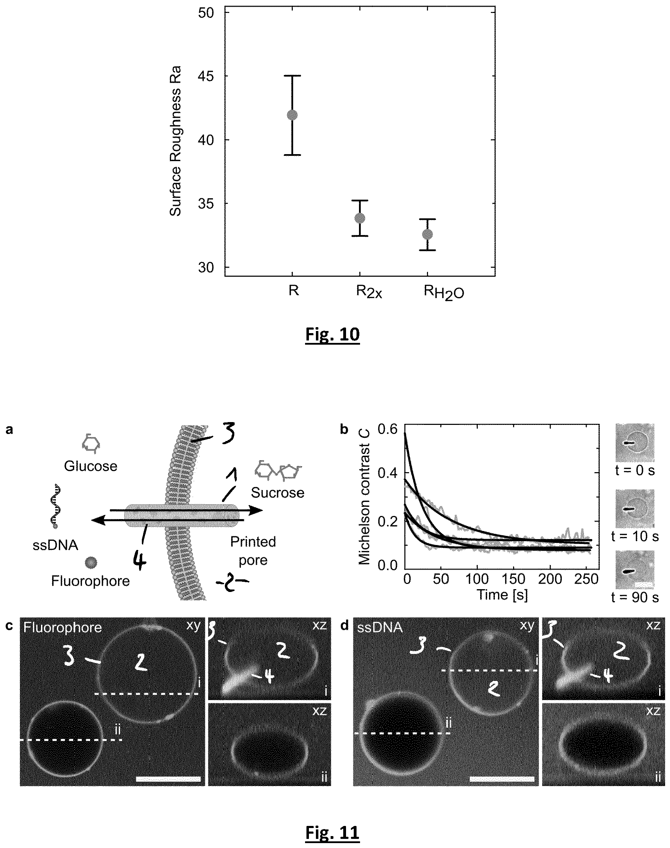

The plot of Fig. 10 shows surface roughness in terms of arithmetical mean deviation Ra as determined from AFM images of polymerized photoresist (R) used for printing inside GVUs, polymerized photoresist with twofold LAP and PEGDA concentration (R$_{2x}$) and polymerized photoresist in water without any sucrose or glucose (R$_{H2O}$) during polymerization. Surface roughness was estimated with the ImageJ plugin SurfCharJ.[1-5] As can be recognized from Fig. 10, surface roughness of photoresist R was higher than for photoresists R$_{2x}$ and R$_{H2O}$.

Fig. 11a shows schematically a printed structure 1, extending through the fluid interface of a compartment 2 in the form of a GUV. The fluid interface is stabilized by a lipid bilayer 3. The printed structure 1 is a porous structure 4. As indicated by the arrows in the schematic illustration of a printed PEGDA hydrogel porous structure across the lipid membrane of a GUV. The pore(s) of the porous structure allow for the passage of various molecules, including glucose, sucrose, a fluorophore and single-stranded DNA (ssDNA).

In Fig. 11b the decay of the Michelson contrast C = (I$_{max}$ - I$_{min}$) / (I$_{max}$ + I$_{min}$) for 5 GUVs as a function over time after printing a pore across the membrane is plotted. Due to exchange of refractive index influencing molecules sucrose and glucose, the Michelson contrast decreases over time, as displayed in representative bright-field optical images taken at the referenced timepoints of 0 s, 10 s and 90 s after printing the pore. An exponential fit (black line) yielded a pore permeability coefficient of P = 0.48 $\pm$ 0.25 $\mu$m s$^{-1}$ for the glucose/sucrose exchange. The scale bar indicated in the bright field image of t = 90 s represents 20 $\mu$m and corresponds to all of the bight field images shown in Fig. 11b.

Representative confocal images of two adjacent GUVs (red, $\lambda_{ex}$ = 488 nm) in the xy- (left) and an xz-plane (right, as indicated by white dashed line) are shown in Fig. 11c. A hydrogel porous structure 4 (yellow, $\lambda_{ex}$ = 561 nm, visible in the xz plane) was printed into the upper GUV (i), leading to the influx of the membrane-impermeable fluorophore Alexa Fluor 647 NHS (green, $\lambda_{ex}$ = 640 nm, visible as light grey in Fig. 11c). No influx was detected for the adjacent GUV without the printed pore (ii). The scalebar in the image of the xy-plane represents 20 $\mu$m.

Further representative confocal images of two adjacent GUVs, similar as described in Fig. 11c, are shown in in Fig. 11d. The confocal images demonstrate that also a 13 base-long single-stranded DNA (green, labelled with Atto647N, $\lambda_{ex}$ = 640 nm, visible as light grey in Fig. 11d) can diffuse into the GUV across the printed pore. The scalebar in the image of the xy-plane represents 20 $\mu$m.

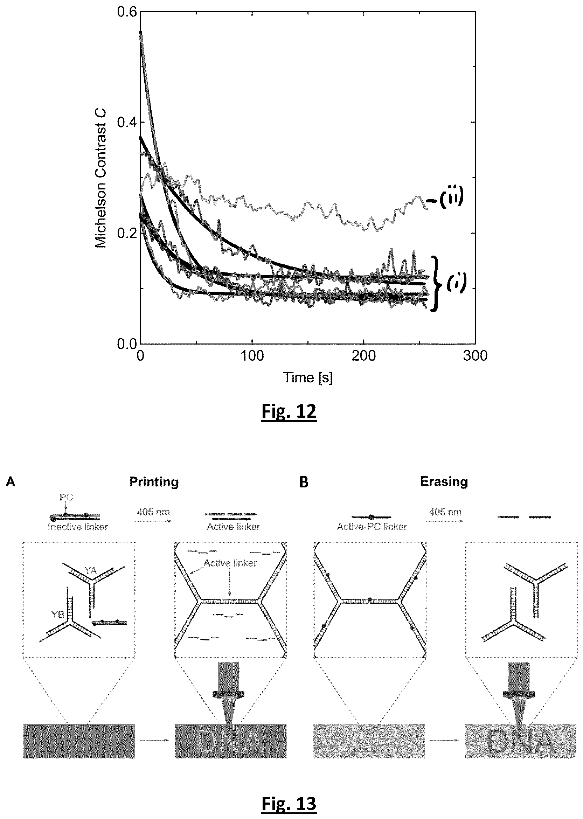

Fig. 12 shows the development of the Michelson contrast C = ($I_{max}$ - $I_{min}$) / ($I_{max}$ + $I_{min}$) for (i) 5 GUVs as a function of time after printing a pore across the membrane (grey) and for (ii) a GUV without printing a pore across the membrane (red) as control, latter one showing no exponential decrease in optical contrast.

In Fig. 13A and 13B a DNA hydrogel that can be used as a negative photoresist (Fig. 13A) or as a positive photoresist (Fig. 13B) is schematically illustrated.

The following further exemplifies the present invention and provides experimental details. It is to be understood that the present invention is not limited to these details below, even though they may be regarded as preferred embodiments, either taken alone or in combination with each other.

3D laser printing of hydrogel structures inside GUVs:

Fig. 1 illustrates the proposed concept to write custom-shaped 3D structures inside preformed compartments by femtosecond two-photon polymerization. Importantly, two-photon polymerization allows to trigger the polymerization at a desired 3D position, leading to a polymerized volume element, which is referred to as the voxel 5. In particular, two-photon absorption of the photoinitiator produces free radicals, which, in turn, initiate the radical polymerization of the resist monomers. This offers the unique yet unexplored possibility to print inside a preformed compartment in a non-destructive manner with full spatio-temporal control. While the general concept to print inside compartments may become applicable in diverse fields of science and technology, we set out to demonstrate its relevance for bottom-up synthetic biology. As an initial proof of principle, we successfully demonstrated printing of arbitrary objects inside water-in-oil droplets (Fig. 2). Nevertheless, synthetic cells enclosed by a lipid bilayer better mimic cellular membranes, which is why we chose GUVs as a more relevant compartment type [39, 40, 41]. Printing inside GUVs is especially challenging due to their mechanical instability [2] and the chemical photoresist requirements. A suitable resist preferably fulfills several criteria:

(i) It is preferably soluble in an aqueous solvent.

(ii) The encapsulation into GUVs should be possible at sufficiently high concentrations without compromising the GUV stability.

(iii) Preferably, it should be possible to develop the structures after printing, which requires suitable strategies to remove the photoinitiator and unpolymerized resist components from the GUV lumen.

(iv) The printing process itself preferably causes no movement or destruction of the GUV.

For the Examples described herein, commonly used water-soluble resist components (Requirement (i)) were chosen, namely the photoinitiator lithium phenyl-2,4,6-trimethylbenzoylphosphinate (LAP), the prepolymer poly(ethylene glycol) diacrylate 575 (PEGDA) [42, 43] and the fluorescent acryloxyethyl thiocarbamoyl rhodamine B monomer (Rhodamine B acrylate) for imaging purposes. Additionally, the resist was supplemented with sucrose at a high osmolarity (800 mM) to buffer osmotic pressure fluctuations which could damage the GUVs [17].

Next, we set out to test if Requirements (ii) and (iii) can be fulfilled, i.e., if the resist can be brought into the GUV and if excess components can be removed after printing.

GUVs were prepared with a conventional lipid composition (99 % DOPC, 1 % ATTO633-DOPE) using the electroformation method [9]. When mixing GUVs and the photoresist components, confocal imaging revealed the influx of the fluoresecent Rhodamine B acrylate across the lipid bilayer membrane into the GUV lumen (Fig. 3a), equilibrating the concentrations inside and outside of the GUV. Since Rhodamine B acrylate represents the largest and most polar component of the photoresist, this finding hints that also the other resist components can be brought into the GUVs by diffusion (Requirement (ii)).

More importantly, we found that the removal of the resist from the GUV lumen can be achieved by simple dilution, resulting in outflux from the GUV by passive diffusion (Fig. 3a, iii). This means that it is possible to develop encapsulated structures after printing inside the GUV (Requirement (iii)).

To gain quantitative insights into the Rhodamine B acrylate influx into GUVs, the fluorescence intensity ratio inside and outside of GUVs, $I_{in}/I_{out}$, was measured over time, yielding a membrane permeability coefficient of $2.301 \pm 0.016$ nm s—1 (Fig. 3b, further information provided below), which is comparable to reported literature values for the permeability of the antibiotic norfloxacin [44] or the charged compound bicarbonate [45].

The resist was polymerized inside the GUV by two-photon 3D laser printing. This observation is a direct proof for the influx of all resist components. As visible in the microscopy image in Fig. 3c (see inset), a rod-shaped element was successfully printed into the lumen of the GUV. The printing success rate was used as an indirect way to determine the membrane permeability of the non-fluorescent components. For this purpose, PEGDA or LAP was added to GUVs that were pre-incubated with the other resist components. Subsequently, the fraction of successful printing attempts, $N_{pol}/N_{tot}$, was quantified for 30 GUVs per time point over the course of up to 100 minutes. An increase of the printing success rate over time was observed because of the diffusion of the respective resist component into the GUVs (Fig. 3c).

Due to their increased surface-to-volume ratio, printing in smaller GUVs was possible at earlier time points (Fig. 4). In most of the unsuccessful printing attempts, the GUV remained intact but no structure appeared inside, likely due to insufficient supply of one of the resist components in the GUV lumen.

Importantly, the GUVs did not move during the printing process, despite potential laser heating, once they settled due to gravity in a glucose-sucrose gradient (Requirement (iv)).

In more detail, after adding LAP to GUVs, it took $24.27 \pm 1.07$ min to achieve a 50 % printing success rate. Having determined the minimal LAP concentration required for printing (Fig. 5), this yields a membrane permeability of $0.987 \pm 0.325$ nm s—1 (further details are indicated below).

PEGDA was found to diffuse faster across the membrane, such that printing in 50 % of the GUVs was already possible after $11.48 \pm 0.88$ min, corresponding to a membrane permeability of $3.875 \pm 1.330$ nm s—1. As expected, both non-fluorescent components have a higher membrane permeability compared to Rhodamine B acrylate since they are smaller in size. When adding PEGDA and LAP at the same time, we achieve a 50 % printing success ratio at a later time point after $44.83 \pm 2.68$ min, potentially due to the increased access resistance. Most importantly, it should be highlighted that printing was successful in over 88 % of the GUVs after 100 min incubation with the resist components. If printing was unsuccessful despite sufficiently long incubation, this was typically the case because the GUV bursted during the printing process, when the 3D positioning of the polymerization voxel was insufficiently accurate and polymerization was triggered in very close proximity to the lipid bilayer.

The high printing success rate of a simple structure as described above, allowed the printing of more complex 2D a 3D shapes into GUVs and to visualize them by confocal fluorescence microscopy. Fig. 3d shows various 2D hydrogel structures printed inside GUVs, including letters, numbers and symbols. After printing, they freely diffused inside the GUV lumen and slowly settled to the bottom of the GUVs due to gravity. Printing speeds ranging from 1 mm s—1 to 2 mm s—1 could be achieved for manufacturing all layers at near-constant position of the structure itself. Capitalizing on the high spatial resolution of femtosecond two-photon polymerization, Fig. 3e presents a 3D reconstruction of a 16 $\mu$m high 3D cube frame inside a 40 $\mu$m GUV.

This demonstrates an exemplary way for enriching the inner volume of GUVs with photopolymerizable hydrogel components via diffusion across the lipid bilayer and demonstrated the deterministic polymerization of various structures in 2D and 3D inside GUVs. This concept can also be extended to other compartment types like water-in-oil droplets (Fig. 2). Moreover, if lower resolution along the z-direction can be tolerated, printing can be achieved with the laser of a confocal microscope or other types of illumination (Fig. 6). This aspect makes printing inside compartments also broadly applicable beyond synthetic biology.

Lipid membrane and hydrogel properties:

Having confirmed that femtosecond two-photon polymerization inside GUVs does not destroy them (Requirement (iv)), the effects of the photoresist and two-photon 3D laser printing process on the lipid bilayer was investigated. Specifically, unintentional alterations of the lipid diffusivity, which is a crucial indicator for membrane property changes, such as resist-membrane interactions, oxidation [46] or changes in membrane composition due to the presence of the photoresist in the membrane were investigated.

First, it was confirmed with fluorescence recovery after photobleaching (FRAP) measurements (further details are provided below) that the membrane of GUVs containing a printed structure inside their lumen remained diffusive (Fig. 7a).

The fluorescence of the bleached area recovered within seconds. An exponential fit yields the diffusion coefficient D of the lipids for different conditions, namely prior to resist encapsulation, before and after equilibration of the resist concentration inside and outside the GUVs (i.e., 0.25 h and 2 h after adding the photoresist to the GUVs, respectively) and after printing a rod structure inside the GUV lumen (Fig. 7b). Directly after addition of the resist (0.25 h), the lipid diffusion coefficient D increased slightly but significantly (D = 3.455 $\pm$ 0.517 $\mu m^2 s^{-1}$ and D = 2.887 $\pm$ 0.640 $\mu m^2 s^{-1}$, respectively, p = 0.029), likely due to the imbalanced distribution of the photoresist at this time point. In contrast, 2 h after photoresist addition, when the concentrations inside and outside of the GUVs have equilibrated, the lipid diffusion coefficient decreased slightly. This is likely due to the higher viscosity of the solution in the presence of the resist and the presence of resist components in the membrane (p = 0.004). Most importantly, the printing process did not affect the diffusion coefficient significantly (D = 2.129 $\pm$ 0.610 $\mu m^2 s^{-1}$, p=0.133), fulfilling Requirement (iv).

In order to derive functionality for the printed hydrogels, their microscopic structure was investigated. FRAP experiments confirmed that the hydrogel is polymerized and hence not diffusive (Fig. 8). Atomic force microscopy (AFM) of the polymerized photoresist revealed sub-micron-sized pores inside the hydrogel (Fig. 7c). It was found that the pore size can be tuned by changing the resist concentration as well as the concentration of sucrose (Fig. 9). More specifically, Fig. 7d quantifies the pore size distribution of the polymerized photoresist used for printing inside GUVs (R) in comparison to a resist with a twofold increased concentration of PEGDA and LAP ($R_{2x}$) and a resist without addition of sucrose and glucose ($R_{H2O}$). The surface roughness (Fig. 10) and the pore size of photoresist R is increased significantly in comparison to the resist variations $R_{2x}$ (p = 0.010) and $R_{H2O}$ (p = 0.005). This leads to the conclusion that both, the high water content (88.9 vol%) and addition of sugars, which can act as porogens [47], increase hydrogel porosity in the sub-micron regime.

This shows that the membrane remains intact after printing and that the polymerized hydrogel is porous. This opens up exciting opportunities for applications of 3D laser printing in compartments, such as lipid vesicles in the context of bottom-up synthetic biology.

<u>3D laser printing of a transmembrane pore:</u>

Further to the above, a transmembrane pore that spans the lipid bilayer was printed. Due to the porous nature of the printed hydrogel, a structure that is written or printed across the membrane provides a passage for biomolecular cargo as illustrated in Fig. 11a. At the same time, printing across the membrane sets yet another technological challenge concerning the feasibility and the stability of the GUVs.

Importantly, it was found that printing across the lipid membrane is possible without destruction of the GUVs by applying the method of the present invention.

After two-photon polymerization of the respective area, a hydrogel structure with a diameter of approximately 5 $\mu$m clearly spanned the GUV membrane as visible in the brightfield image in Fig. 11b. Illumination likely supports the formation of transient lipid pores in the membrane which possibly expand and merge such that resist components that are present in the membrane can polymerize. Localized lipid peroxidation or damage may occur, but the incorporation of such lipids in the membrane is likely to be unstable leading to their exclusion [17].

Membrane-spanning structures could be printed in 41.5 % of printing attempts (n=59). In the other cases GUVs bursted and collapsed. Increasing the laser intensity by 10 % resulted in a decreased success ratio of 32 % (n=50), enhancing the probability of GUV destruction. Nevertheless, printing success was possible at different laser intensities.

To test whether the printed transmembrane structure acts as a pore and enables substance exchange between the interior and the environment of the GUV, a glucose-sucrose gradient across the GUV membrane was used. The refractive-index mismatch between the glucose outside and the sucrose solution inside the GUV causes an optical contrast which disappears if glucose and sucrose are exchanged across the lipid membrane. Fig. 11b plots the decrease of the Michelson contrast C = ($I_{max}$ — $I_{min}$) / ($I_{max}$ + $I_{min}$) over time after two-photon polymerization of a rod structure across the lipid bilayer, with Imax and Imin being the maximum and minimum intensity value across the lipid bilayer, respectively (n=5). The decrease of the optical contrast indicates the equilibration of the sucrose and glucose concentrations inside and outside of the GUVs. This clearly demonstrates that the nanoporous membrane-spanning hydrogel acts as a channel to enable transport across the lipid bilayer. Exponential fits yielded a permeability coefficient of the pores for sucrose and glucose of 0.48 $\pm$ 0.25 $\mu m s^{-1}$. Negligible decrease in the Michelson contrast occurred for GUVs when no pore was printed (Fig. 12) as expected due to the low membrane permeability of sugars [48].

Next, it was tested if the pores can transport larger and charged molecular cargo. Fig. 11c shows the influx of the fluorophore Alexa Fluor™ 647 NHS ester into GUVs containing a pore (i) whereas it was excluded from an adjacent GUV without a pore (ii). In the xz-plane, the printed pore is clearly visible for GUV (i). Moving on to biologically relevant macromolecular cargo, Fig. 11d shows the influx of single-stranded DNA across a printed hydrogel pore. Again, an adjacent GUV without a pore does not show DNA import, highlighting the advantage of 3D laser printing to induce transport with full spatio-temporal control at the single-GUV level.

The printed transmembrane pore is a very large transmembrane pore, exceeding the size of the nuclear pore complex. In particular, large pores capable of transporting macromolecules across the membrane are often difficult to isolate and to reconstitute in synthetic cells. However, applying the method of the present invention, in particular the 3D laser printing described above, such large transmembrane pores can be produced within a compartment.

The above described Examples were prepared according to the following experimental details.

Materials:

18:1 1,2-dioleoyl-sn-glycero-3-phosphoethanolamine-N-(lissamine rhodamine B sulfonyl) (ammonium salt) (Liss Rhod PE) and 18:1 1,2-dioleoyl-sn-glycero-3-phosphocholine (DOPC) were purchased from Avanti Polar Lipids, Inc. 1,2-dioleoyl-sn-glycero-3-phosphoethanolamine-ATTO633 (ATTO633-DOPE) and 1,2-dioleoyl-sn-glycero-3-phosphoethanolamine-ATTO488 (ATTO488-DOPE) were purchased from ATTO-TEC GmbH. Poly(ethylene glycol) diacrylate (PEGDA, Mw $\approx$ 575), Lithium phenyl-2,4,6-trimethylbenzoylphosphinate (LAP), acryloxyethyl thiocarbamoyl rhodamine B (Rhodamine B acrylate), 3-(trimethoxysilyl) propyl methacrylate (TMSPMA), sucrose, glucose and poly(vinyl alcohol) (PVA, Mw 13 000 to 23 000) were purchased from Sigma-Aldrich. Poly(dimethylsiloxane) (PDMS, Syl-gard 184) was purchased from Dow Corning. Alexa Fluor™ 647 NHS Ester (Succinimidyl Ester) was purchased from Thermo Fisher Scientific Inc. Indium tin oxide (ITO) coated glass coverslips were purchased from Visiontek Systems Ltd. 5'-Atto 647N TTTTTTAATTTTT 3' single-stranded DNA (Atto647N ssDNA) was purchased from biomers.net GmbH (purification: HPLC). Picodent twinsil® was purchased from picodent®. Precision cover glasses (thickness No. 1.5H: 170 $\pm$ 5 $\mu$m, 24 mm $\times$ 60 mm and 18mm $\times$ 18 mm) were purchased from Paul Marienfeld GmbH & Co. KG.

GUV electroformation:

Giant unilamellar vesicles (GUVs) were electroformed in 800 mM sucrose using a Vesicle Prep Pro device (Nanion Technologies GmbH) [9, 17]. Briefly, 40 $\mu$l of a lipid mix (99 % DOPC and either 1 % ATTO633-DOPE or 1 % ATTO488-DOPE), dissolved in chloroform at a concentration of 5 mM, were spread homogeneously on the conductive site of an ITO coated glass slide. Subsequently, the lipid-coated ITO slide was desiccated for 30 min in order to remove remaining chloroform. A rubber ring was placed on top of the lipid-coated ITO slide, which then was filled up with 275 $\mu$l 800 mM of an aqueous sucrose solution. A sealed chamber was created by placing another ITO slide on top, afterwards the electrodes were connected with the conductive sides of the ITO slides and the pre-installed Standard program was run, generating an AC field of 3 V at 5 Hz for 2 h at 37 °C.

Photoresist permeation into GUVs:

Prior to laser writing, a photoresist containing 249 mg ml—1 PEGDA 575 as monomer, 24 mg ml—1 LAP as photoinitiator and 800 mM glucose was mixed at a volumetric ratio of 1:1 with the GUV solution. 0.01 mg ml—+1 Rhodamine B acrylate were added to the final solution for fluorescence microscopy. For the influx of Alexa Fluor™ 647 NHS Ester or Atto647N ssDNA into GUVs, the volumetric ratio of photoresist, GUV solution and fluorophore or fluorophore-conjugated ssDNA was 20:19:1.

Glass slide coating:

Cover glasses were coated either with PDMS (Fig. 3d) or TMSPMA upon plasma activation. Briefly, cover glasses were plasma cleaned for 35 s with oxygen plasma at 0.4 mbar and 200 W (PVA TePla AG). Afterwards, PDMS (precursor:curing agent 10:1 weight ratio) was spread onto the cover glasses or they were bathed in TMSPMA (5 vol% in Toluene) and placed into a 60 °C oven for 3 h or 1 h, respectively, prior to rinsing with ethanol and water. In order to prevent vesicle fusion with the cover glasses, 200 $\mu$l 50 mg ml—1 PVA in water was spread onto cover glasses and blow dried with nitrogen after 5 min.

3D laser printing:

For structure fabrication, a commercial 3D laser printing setup (Photonic Professional GT, Nanoscribe GmbH) equipped with a 25x, NA=0.8 oil immersion objective and a 25x, NA=0.8 water immersion objective was used for fabricating 2D and 3D structures, respectively. The printing solution containing GUVs and photoresist was filled into a glass observation chamber made of two coated cover glasses, doublesided adhesive tape as spacer and was sealed by two-component glue picodent twinsil®.

STL files were designed using Blender (version 2.92) and processed via DeScribe (version 2.5.5). Typically a laser power of 80 % or 90 % was used, wherein 100 % correspond to 50 mW at the backfocal plane, and a scanning speed of 1 mm s—1 to 2 mm s—1 or 6 mm s—1 for 2D structures and 3 mm s—1 for the 3D structure and printed pores. The slicing and hatching parameters were set to 300 nm and 200 nm, respectively.

PEGDA and LAP membrane permeability:

In order to determine the membrane permeability of PEGDA or LAP, GUVs were incubated for 2 h in 800 mM sucrose and additional 12 mg LAP or 11.1 vol% PEGDA, respectively. Afterwards, the solution was mixed with a 800 mM glucose, 12 mg LAP and 22.2 % PEGDA solution or 800 mM glucose, 24 mg LAP and 11.1 % PEGDA solution, respectively, in a volumetric ratio of 1:1. This results in an increasing concentration of PEGDA or LAP over time, whereas the concentration of the other resist components remains constant.

Confocal microscopy:

Fluorescence microscopy was performed using an LSM 800 or a LSM 900 confocal laser scanning microscope (Carl Zeiss AG). The Rhodamine B acrylate influx study was performed using a 20x air objective (Plan-Apochromat 20x/0.8 M27, Carl Zeiss AG) on an LSM 900. FRAP measurements and all other fluorescence images were taken at an LSM 800, using a 20x air objective (Plan-Apochromat $20\times$/0.8 M27, Carl Zeiss AG), a 40x water objective (C-Apochromat $40\times$/1.20 W Korr, Carl Zeiss AG) or a 63x oil objective (Plan-Apochromat 63x/1.40 Oil DIC M27). Confocal images were analyzed with ImageJ (version 1.53c) and brightness and contrast adjusted.

FRAP measurements:

For FRAP measurements, a circular area of 5 $\mu$m in diameter was defined as the bleaching and imaging region and a frame time of 116 ms was set. Using the integrated bleaching tool of the LSM 800, 4 images were acquired prior to one bleaching cycle with the 561 nm laser line at 100 %, followed by a subsequent time series of 65 cycles. The diffusion coefficients, derived from 10-12 GUVs per condition, were determined via a MATLAB (MathWorks, Inc.) script [5].

Fabrication of hydrogel blocks for atomic force microscopy:

For AFM measurements, glass slides (Menzel Gläser, thickness: 1.0 $\mu$m to 1.2 $\mu$m, Thermo Scientific) were coated with TMSPMA as explained above. A 60 $\mu$m high observation chamber was built and the following resists were polymerized: R: 11.1 vol% PEGDA, 12 mg ml$^{-1}$ LAP, 400 mM sucrose, 400 mM glucose. $R_{2x}$: 22.2 vol% PEGDA, 24 mg ml$^{-1}$ LAP, 800 mM glucose. $R_{H2O}$: 11.1 vol% PEGDA, 12 mg ml$^{-1}$ LAP.
They were flushed into the observation chamber and polymerized by acquiring per frame repeated twofold averaged $512 \times 512$ pixel images with a pixel size of 1.25 $\mu$m and a pixel time of 1.52 $\mu$s with a 405 nm laser diode at 20 % laser intensity, using a 20x air objective (Plan-Apochromat $20\times$/0.8 M27, Carl Zeiss AG) on an LSM 900. After Polymerization, the chambers were immersed with ethanol in order to remove the sticky tape and the top glass slide. Next, slides with polymerized hydrogel on top were soaked with MilliQ water for at least 24h prior to AFM measurements.

Atomic force microscopy:

Atomic force microscopy (AFM) was conducted in liquid using a Nanowizard Ultra Speed 2 (Bruker) with a BL-AC40TS cantilever (Olympus, f = 110 kHz, k = 0.09 N/m) in QI-mode, using a peak force of 139.3 pN. The resolution was set to $256 \times 256$ pixel with a pixel time of 9.4 ms. AFM images were processed with JPK Data Processing (version 7.0.137).

Statistical analysis:

Statistical analysis, non-linear regression and data plotting were carried out with GraphPad Prism (version 9.1.2) and in python (version 3.8.8). All figures were compiled with Inkscape (version 1.0.2). Fig. 2a and 7b display mean values and their standard deviation, based on n > 17 and n > 10 data points per conditions, respectively. Statistical significance was tested using Welch's t-test for Fig. 7b and a Mann-Whitney test for Fig. 7d.
Additional details for the above experiments are described in the following:

Membrane and pore permeability:

The estimation of membrane permeability coefficients was carried out for the flux of molecules through a spherical GUV with membrane thickness d and membrane area $4\pi r^2$, based on Fick's first law of diffusion.[1-1] For the permeability of the hydrogel pore for sucrose and glucose, one has to consider the flux through the cross sectional area of the pore $A_{pore}$. Hence, the flux J will be described by

$$\frac{J}{A_{\text{pore}}} = -KD\frac{dc}{dr} \tag{1}$$

Which gives upon integration

$$J(t) = A_{\text{pore}}\frac{KD}{d}(c_{\text{out}} - c_{\text{in}}(t)) \tag{2}$$

where K is the partition coefficient, D the diffusion coefficient, cout the concentration outside of the GUV and cin the concentration inside of the GUV.

In addition, the flux can also described by the change of concentration inside of the GUV:

$$\frac{dc(t)}{dt} = \frac{3A_{\text{pore}}}{4\pi r^3}P(c_{\text{out}} - c_{\text{in}}(t)) \tag{4}$$

where P = KD/d is the permeability coefficient.

The solution for the Michelson contrast C, given the boundary condition $C_{\text{in}}(t = 0) = 0$, is

$$C(t) = 1 - e^{-\frac{3A_{\text{pore}}P}{4\pi r^3}t} \tag{5}$$

Membrane permeability for printing attempts:

We use the interdependence of the permeability and the concentration inside of a GUV $C_{\text{in}}$ [1] to determine the membrane permeability P via printing attempts:

$$\ln\left(\frac{c_{\text{out}} - c_{\text{in}}(t)}{c_{\text{out}}}\right) = -3\frac{Pt}{R} \tag{6}$$

or

$$P(t) = -\frac{R}{3t}\ln\left(1 - \frac{c_{\text{in}}(t)}{c_{\text{out}}}\right), \tag{7}$$

where R is the GUV radius, $C_{\text{out}}$ the concentration outside of the GUV and t the time.

We used parameters of R = 12.5 $\pm$ 2.5 $\mu$m, as GUVs with a diameter of 20 $\mu$m to 30 $\mu$m were chosen for the analysis, $C_{\text{out}}$ = 11.1 vol% or $C_{\text{out}}$ = 12 mg mL—1 for PEGDA and LAP, respectively, $C_{\text{in}}$ = 5.25 $\pm$ 0.25 vol% or $C_{\text{in}}$ = 3.50 $\pm$ 0.25 mg mL—1 for PEGDA and LAP, respectively (Fig. 5) and t = 11.48 $\pm$ 0.88 min or t = 24.27 $\pm$ 1.07 min for PEGDA and LAP, respectively, according to Fig. 3c.

The resulting membrane permeabilities are 3.875 $\pm$ 1.330 nm s—1 for PEGDA and 0.987 $\pm$ 0.325 nm s—1 for LAP, where the error is estimated by propagation of uncertainties.

FRAP analysis:

FRAP measurements were performed and analysed according to previos work.[1-2] Briefly, all fluorescence intensity values / were normalized on the average of all fluorescence intensities acquired before bleaching, $I_{\text{pre}}$, namely $n_{\text{pre}}$ = 4 images:

$$I_{\text{norm}} = \frac{I}{\sum_{i=1}^{n}\frac{I_{\text{pre},i}}{n}} \tag{8}$$

Furthermore, a non-linear least-squared exponential fit of the form

$$I_{\mathrm{norm}} = a\big(1 - e^{\lambda t}\big) \tag{9}$$

was performed, where $\lambda$ is the exponential decay coefficient, which in turn was used to calculate the half-recovery time

$$\tau_{1/2} = \frac{-\log(0.5)}{\lambda}. \tag{10}$$

Eventually, the diffusion coefficient D was calculated:[1-3,1-4]

$$D = 0.32\frac{r^2}{\tau_{1/2}}, \tag{11}$$

where r is the radius of the bleached spot, which was set to 2.5 $\mu$m.

In the following the printing and erasing of DNA hydrogel is described by reference to an exemplary embodiment. The DNA hydrogel used for printing corresponds to the one described by Kasahara et al., in "Photolithographic shape control of DNA hydrogels by photo-activated self-assembly of DNA nanostructures", APL Bioengineering 4, 016109 (2020); https://doi.org/10.1063/1.5132929.

Fig. 13 shows schematically the functioning of the DNA hydrogel, wherein Fig. 13A shows the DNA hydrogel when used as a negative resist and Fig. 13B shows the DNA hydrogel when used as a positive resist. The DNA hydrogel contains two different Y-shaped DNA nanostructures having sticky ends, indicated as YA and YB in Fig. 13A.

The sticky ends of the different Y-shaped DNA nanostructures YA and YB are not compatible to one another. Further, the resist includes a cross-linker DNA sequence, having sequences complementary to those of the sticky ends of the different Y-shaped DNA nanostructures YA and YB. In an inactive state of the linker, indicated at the left side of Fig. 13A, the complementary DNA-sequences are non-accessible for the sticky ends of the Y-shaped DNA nanostructures. By irradiating with light, for example a 405 nm laser, photocleavable groups PC within the inactive linker are cleaved and the sticky ends of the linker become accessible for the sticky ends of the Y-shaped DNA nanostructures. The cross-linker can therefore connect the DNA nanostructures YA and YB and the photoresist hardens.

For the negative resist, the underlying mechanism is explained in Fig. 13B. The active linker includes also a photocleavable group which can be cleaved by irradiating with light, for example 405 nm. The photocleavable group is located between two DNA-sequences of the linker. After cleaving the photocleavable group, the two DNA-sequences of the linker are separated from one another. In consequence, the previously linked DNA nanostructures are also separated from one another, resulting in dissolving the hydrogel at the location where exposed to light.

In principle it is possible to combine the negative resist and the positive resist, when the inactive cross-linker used for the negative resist comprises different types of photocleavable groups which cleave selectively at different wavelengths, for example one at 405 nm and another one at a different wavelength). A first type of photocleavable group (not shown in Fig. 13B), as shown for example in Fig. 13A, must be cleaved to make the sticky ends of the linker accessible for the sticky ends of the DNA nanostructures YA and YB. Thereby, the hydrogel hardens. A second photocleavable group (not shown in Fig. 13A) is provided between the DNA sequences of the linker, as shown for example in Fig. 13B, and can be cleaved when being irradiated with light of a second wavelength, thereby cancelling the linkage of the DNA nanostructures YA and YB.

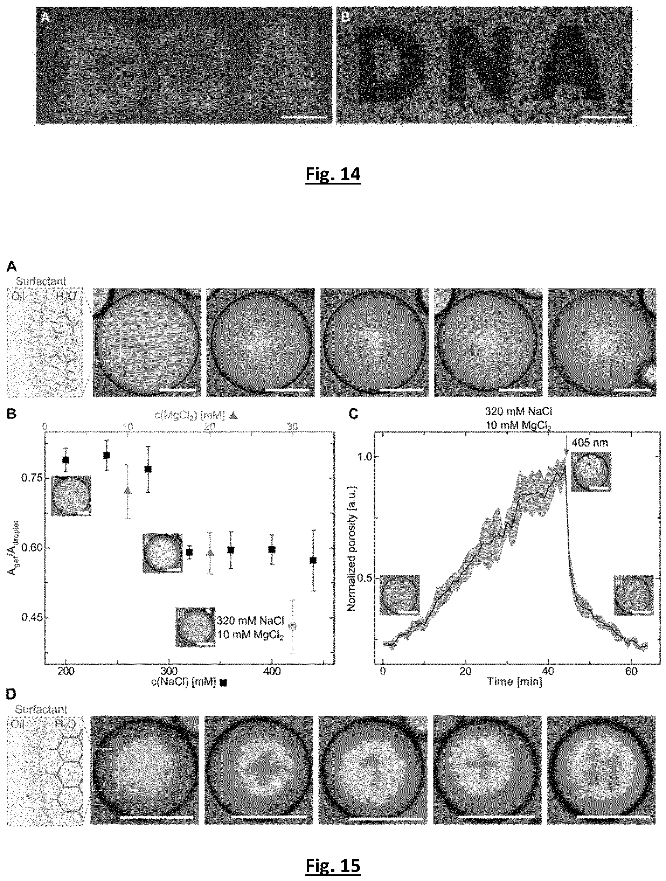

Fig. 14A shows a print of the word "DNA" by irradiating the negative resist DNA hydrogel as described above under reference to Fig. 13A (not within a compartment). Fig. 14B shows a hardened DNA hydrogel, in which the word DNA has been erased, i.e. this corresponds to the positive resist described above under reference to Fig. 13B. Accordingly, it was shown that the DNA hydrogel can be structured in a targeted manner, using focused light. Images of Fig. 14 are confocal microscopy images showing the printing and erasing of the DNA hydrogel in bulk A: Confocal microscopy image ($\lambda_{ex}$ = 561 nm) of a printed structure depicting the word "DNA". B: Confocal microscopy image ($\lambda_{ex}$ = 561 nm) of an erased structure depicting the word "DNA". Scale bars in the images of Fig. 14 represent 100 $\mu$m.

Fig. 15 shows the printing (Fig. 15A) and erasing (Fig. 15D) of DNA hydrogels in water-in-oil droplets having a surfactant stabilized interface. The sketch of Fig. 15A shows the droplet membrane and DNA encapsulation as well as overlays of confocal florescence ($\lambda_{ex}$ = 561 nm) and bright field images of printed DNA hydrogel structures in water-in-oil droplets, such as "+" (i), "1" (ii), $\div$ (iii), # (iv).

Fig. 15B shows the formation of the DNA hydrogel used as positive resist by self-assembly of the components, as explained in Fig. 13B, in dependency of the salt concentration. The black squares indicate different NaCl concentrations in the range of 200 mM to around 450 mM. The grey triangles indicate different $MgCl_2$ concentrations of 10 mM and 20 mM, respectively. The grey circle indicates a concentration of 30 mM $MgCl_2$ and 420 mM NaCl. The salt concentration influences the density and porosity of the DNA hydrogel, due to interaction of the salt ions with the negatively charged backbone of the DNA fragments of the photoresist, including the the active but photocleavable linker. Micrographs included in Fig. 15 show the formation of the DNA hydrogel at i) a NaCl concentration of 200 mM, ii) a NaCl concentration of 320 mM and iii) a NaCl concentration of 320 mM and a $MgCl_2$ concetration of 10 mM. At lower salt concentrations, the ratio of the area of the gel to the area of the droplet, $A_{gel}/A_{droplet}$, as observed in the micrograph decreases, indicating that the density of the hydrogel increases. The scale bars indicated in the micrographs of Fig. 15B represent 10 $\mu$m.

Fig. 15C shows the normalized porosity of the DNA hydrogel of Fig. 13B over time. After all components of the positive photoresist are inside the compartment, the porosity increases. This indicates the self-assembly of the photoresist components, including the active but photocleavable linker. Micrographs i) and ii) were obtained from a droplet, including said positive photoresist directly after all components thereof were present inside the droplet and after 45 minutes. In the image obtained after 45 minutes (ii) the DNA hydrogel is clearly visible. After 45 minutes the DNA hydrogel was irradiated with light having a wavelength of 405 nm, which is suitable for cleaving the photocleavable linker. After irradiation, porosity drops immediately, indicating the degradation of the DNA hydrogel. Degradation of the DNA hydrogel is also confirmed by micrograph iii, in which the DNA hydrogel is no longer visible. The scale bars indicated in the micrographs of Fig. 15C represent 10 $\mu$m.

Similarly, as in Fig. 15A, in Fig. 15D the sketch shows the droplet membrane and the encapsulated DNA hydrogel as well as overlays of confocal florescence ($\lambda_{ex}$ = 561 nm) and bright filed images of erased DNA hydrogel structures in water-in-oil droplets, such as "+" (i), "1" (ii), $\div$ (iii), # (iv).

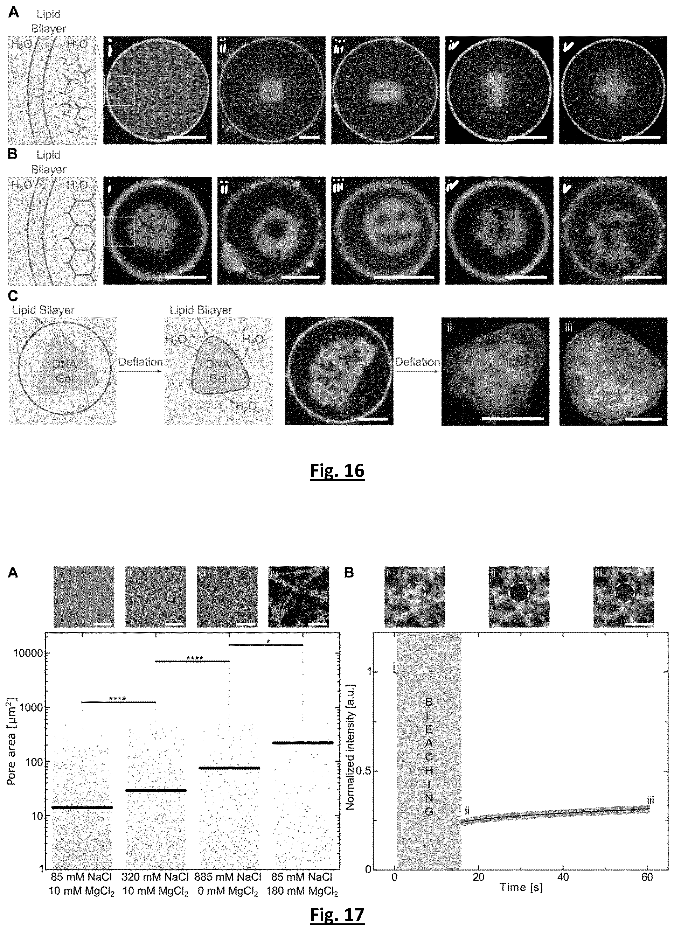

Fig. 16 illustrates the printing and erasing of DNA hydrogels inside giant unilamellar vesicles.

The sketch of Fig. 16A shows the DNA monomers and inactive linker inside the confinement of a lipid bilayer of a GUV. Overlaid confocal florescence images ($\lambda_{ex}$ = 561 nm (DNA); $\lambda_{ex}$ = 488 nm (lipids)) of Fig. 16A show (i) the DNA photoresist with the inactive linker, and (ii) to (v) several printed structures in GUVs, such as a square (ii), "-" (iii), "1" (iv) and "+" (v). The scale bars indicated in Fig. 16A represent 10 $\mu$m.

Similarly as for Fig. 16A, the sketch of Fig 16B illustrates the DNA hydrogel with the active but photocleavable linker inside the confinement of a lipid bilayer of a GUV. Overlaid confocal florescence images ($\lambda_{ex}$ = 561 nm (DNA); $\lambda_{ex}$ = 488 nm (lipids)) of Fig. 16B show (i) the DNA photoresist with the uncleaved linker, and (i) to (ii) several erased structures in GUVs, such as a circle (ii), ":)" (iii), "1" (iv) and "T" (v). The scale bars indicated in Fig. 16B represent 10 $\mu$m.

The sketches of Fig. 16C illustrate the adherence of the lipid membrane of the GUVs to the DNA hydrogel following deflation and the loss of water. Further, Fig. 16C shows overlaid confocal florescence images ($\lambda_{ex}$ = 561 nm (DNA); $\lambda_{ex}$ = 488 nm (lipids)) of a GUV before deflation and after deflation, wherein after deflation (micrographs indicated with ii and iii), the deflated GUVs adopts the shape of the internal DNA hydrogel. The scale bars indicated in Fig. 16C represent 10 $\mu$m.

Fig 17 shows results obtained from photocured DNA hydrogel, as illustrated in Fig. 13A. Fig. 17A shows porosities of DNA hydrogels obtained from photoresists having different salt concentrations, as indicated in the graph. The observed porosity increases with the salt concentration, i.e. concentrations of NaCl and $MgCl_2$ have an effect on the porosity. Without being bound by a theory, it is assumed that the ions from the dissolved salts, in particular the cations, interact with the negatively charged DNA backbones of the photoresist. By compensating the negative chage of the backbone, the cations of the dissolved salts reduce repelling forces between the backbones. This may explain the observed higher porosities of the DNA hydrogel at higher salt concentrations. Further, this may also explain the strong effect observed for the divalent cation $Mg^{2+}$, which is capable of compensating two negative charges of the DNA backbone.

Fig. 17B shows the result of a FRAP experiment, confirming the formation of a stable hydrogel. The FRAP experiment of Fig. 17B has similarities to the experiment described when referring to Fig. 8. However, instead the DNA hydrogel negative resist, as explained in Fig. 13A was used. After bleaching, the fluorescence does not return to the bleached area indicated by the dashed circle in the micrographs of Fig. 17B, which indicates that a stable hydrogel is formed.

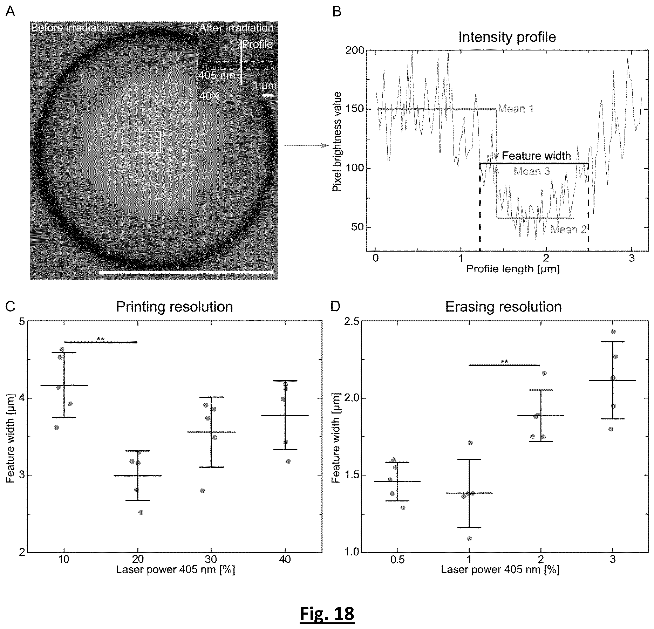

Fig. 18 shows experiments for determining a minimum resolution of printing and erasing the DNA hydrogel photresists explained in Fig. 13A and 13B. Fig. 18A shows a micrograph of an overlay of confocal fluorescence ($\lambda_{ex}$ = 561nm, Cy3) and brightfield images depicting a DNA-hydrogel-containing water-in-oil droplet. The inset displays a 40x zoomed-in image of the DNA hydrogel and the area irradiated with a 405nm laser for erasing of the DNA hydrogel. The DNA hydrogel of Fig. 18A is the positive resist DNA hydrogel as explained above under reference to Fig. 13B. A vertical line shows where the intensity profile for the feature width measurement was placed. The large scale bar in the image before irradiation represents a lengths of 20$\mu$m, the scalebar in the inset after irradiation corresponds to a length of 1 $\mu$m. Fig. 18B shows the intensity profile of the line indicated in the inset of Fig. 18A with the word "Profile". To calculate the feature width, the mean value of the surrounding DNA hydrogel (indicated with "Mean 1") as well as the mean value of the erased spot (Indicated with "Mean 2") were analyzed. From these, Mean 3 was calculated as the mean between the first two values. The width of the erased area was obtained from the profile graph using Mean 3. For printing the DNA hydrogel, a negative resist, as explained under reference to Fig. 13A was used. The same measurements and calculations were performed as for erasing the DNA hydrogel. Fig. 18C is a graph showing the achieved feature widths at different laser powers during printing. The smallest features of $2.99\mu m$ +- $0.32\mu m$ were achieved using 20% laser power. Below and beyond this, the printed features were enlarged, due to long irradiation times at low laser intensities (10% laser power) and a large focus area at high laser intensities (>20% laser power). An unpaired student's t-test revealed statistically significance between the results at 10% and 20% laser power (p-value: 0.0011). Fig. 18D is a graph depicting the measured features widths for the erased DNA hydrogels. The smallest features of $1.38\mu m$ +- $0.22\mu m$ were achieved at 1% laser power. Similar to the results shown for the printing method, below and beyond this laser power, the method yielded larger features. An unpaired student's t-test revealed statistically significance between the results at 0.5% and 1% laser power (p-value: 0.0036). For this reason, we chose 20% laser power as standard printing and 1% laser power as standard erasing settings. The achievable minimum resolutions depend on the set up and it can be expected that when using a more specialized set up, allowing for a more focused laser beam than a confocal microscope, the minimum resolution can be further reduced.

References

[1] H. Mutschler, T. Robinson, T.-Y. D. Tang, S. Wegner, ChemBioChem 2019, 20, 20 2533.

[2] K. Göpfrich, I. Platzman, J. P. Spatz, Trends in Biotechnology 2018, 36, 9 938.

[3] P. Schwille, J. Spatz, K. Landfester, E. Bodenschatz, S. Herminghaus, V. Sourjik, T. J. Erb, P. Bastiaens, R. Lipowsky, A. Hyman, P. Dabrock, J.-C. Baret, T. Vidakovic-Koch, P. Bieling, R. Dimova, H. Mutschler, T. Robinson, T.-Y. D. Tang, S. Wegner, K. Sundmacher, Angewandte Chemie International Edition 2018, 57, 41 13382.

[4] K. Göpfrich, B. Haller, O. Staufer, Y. Dreher, U. Mersdorf, I. Platzman, J. P. Spatz, ACS Synthetic Biology 2019, 8, 5 937.

[5] M. Weiss, J. P. Frohnmayer, L. T. Benk, B. Haller, J.-W. Janiesch, T. Heitkamp, M. Börsch, R. B. Lira, R. Dimova, R. Lipowsky, E. Bodenschatz, J.-C. Baret, T. Vidakovic-Koch, K. Sundmacher, I. Platzman, J. P. Spatz, Nature Materials 2017, 17, 1 89.

[6] L. V. de Cauter, F. Fanalista, L. van Buren, N. D. Franceschi, E. Godino, S. Bouw, C. Danelon, C. Dekker, G. H. Koenderink, K. A. Ganzinger, ACS Synthetic Biology 2021, 10, 7 1690.

[7] S. Deshpande, Y. Caspi, A. E. C. Meijering, C. Dekker, Nature Communications 2016, 7, 1.

[8] B. C. Buddingh', J. C. M. van Hest, Accounts of Chemical Research 2017, 50, 4 769.

[9] M. I. Angelova, D. S. Dimitrov, Faraday Discussions of the Chemical Society 1986, 81 303.

[10] K. Kurihara, M. Tamura, K. ichiroh Shohda, T. Toyota, K. Suzuki, T. Sugawara, Nature Chemistry 2011, 3, 10 775.

[11] K. Y. Lee, S.-J. Park, K. A. Lee, S.-H. Kim, H. Kim, Y. Meroz, L. Mahadevan, K.-H. Jung, T. K. Ahn, K. K. Parker, K. Shin, Nature Biotechnology 2018, 36, 6 530.

[12] T. Pols, H. R. Sikkema, B. F. Gaastra, J. Frallicciardi, W. M. Smigiel, S. Singh, B. Poolman, Nature Communications 2019, 10, 1.

[13] S. Krishnan, D. Ziegler, V. Arnaut, T. G. Martin, K. Kapsner, K. Henneberg, A. R. Bausch, H. Dietz, F. C. Simmel, Nature Communications 2016, 7, 1.

[14] A. Ohmann, K. Göpfrich, H. Joshi, R. F. Thompson, D. Sobota, N. A. Ranson, A. Aksimentiev, U. F. Keyser, Nucleic Acids Research 2019, 47, 21 11441.

[15] L. Pasotti, N. Politi, S. Zucca, M. G. C. D. Angelis, P. Magni, PLoS ONE 2012, 7, 7 e39407.

[16] A. Jesorka, N. Stepanyants, H. Zhang, B. Ortmen, B. Hakonen, O. Orwar, Nature Protocols 2011, 6, 6 791.

[17] Y. Dreher, K. Jahnke, E. Bobkova, J. P. Spatz, K. G..opfrich, Angewandte Chemie International Edition 2021, 60, 19 10661.

[18] Y.-H. M. Chan, B. van Lengerich, S. G. Boxer, Proceedings of the National Academy of Sciences 2009, 106, 4 979.

[19] S. Deshpande, S. Wunnava, D. Hueting, C. Dekker, Small 2019, 15, 38 1902898.

[20] R. B. Lira, T. Robinson, R. Dimova, K. A. Riske, Biophysical Journal 2019, 116, 1 79.

[21] S. Deshpande, F. Brandenburg, A. Lau, M. G. F. Last, W. K. Spoelstra, L. Reese, S. Wunnava, M. Dogterom, C. Dekker, Nature Communications 2019, 10, 1.

[22] N. Yandrapalli, J. Petit, O. Bäumchen, T. Robinson, Communications Chemistry 2021, 4, 1.

[23] J. W. Hindley, Y. Elani, C. M. McGilvery, S. Ali, C. L. Bevan, R. V. Law, O. Ces, Nature Communications 2018, 9, 1.

[24] M. J. Booth, V. R. Schild, A. D. Graham, S. N. Olof, H. Bayley, Science Advances 2016, 2, 4 e1600056.

[25] E. H. Reed, B. S. Schuster, M. C. Good, D. A. Hammer, ACS Synthetic Biology 2020, 9, 3 500.

[26] C. Chou, D. Young, A. Deiters, Angewandte Chemie International Edition 2009, 48, 32 5950.

[27] K. Jahnke, M. Weiss, C. Weber, I. Platzman, K. Göpfrich, J. P. Spatz, Advanced Biosystems 2020, 4, 9 2000102.

[28] K. Jahnke, N. Ritzmann, J. Fichtler, A. Nitschke, Y. Dreher, T. Abele, G. Hof-haus, I. Platzman, R. R. Schroder, D. J. Muller, J. P. Spatz, K. Göpfrich, Nature Communications 2021, 12, 1.

[29] J.-C. Lin, C.-Y. Chien, C.-L. Lin, B.-Y. Yao, Y.-I. Chen, Y.-H. Liu, Z.-S. Fang, J.-Y. Chen, W. ya Chen, N.-N. Lee, H.-W. Chen, C.-M. J. Hu, Nature Communications 2019, 10, 1.

[30] C. Campillo, B. P'epin-Donat, A. Viallat, Soft Matter 2007, 3, 11 1421.

[31] S. Maruo, O. Nakamura, S. Kawata, Optics Letters 1997, 22, 2 132.

[32] X. Zheng, J. Deotte, M. P. Alonso, G. R. Farquar, T. H. Weisgraber, S. Gem-berling, H. Lee, N. Fang, C. M. Spadaccini, Review of Scientific Instruments 2012, 83, 12 125001.

[33] V. Hahn, P. Kiefer, T. Frenzel, J. Qu, E. Blasco, C. Barner-Kowollik, M. Wegener, Advanced Functional Materials 2020, 30, 26 1907795.

[34] M. Hippler, E. Blasco, J. Qu, M. Tanaka, C. Barner-Kowollik, M. Wegener, M. Bastmeyer, Nature Communications 2019, 10, 1.

[35] D. Jin, Q. Chen, T.-Y. Huang, J. Huang, L. Zhang, H. Duan, Materials Today 2020, 32 19.

[36] J. Song, C. Michas, C. S. Chen, A. E. White, M. W. Grinstaff, Macromolecular Bioscience 2021, 21, 5 2100051.

[37] W. Zhang, P. Soman, K. Meggs, X. Qu, S. Chen, Advanced Functional Materials 2013, 23, 25 3226.

[38] S. Engelhardt, E. Hoch, K. Borchers, W. Meyer, H. Krüger, G. E. M. Tovar, A. Gillner, Biofabrication 2011, 3, 2 025003.

[39] R. Dimova, Annual Review of Biophysics 2019, 48, 1 93.

[40] E. Rideau, R. Dimova, P. Schwille, F. R. Wurm, K. Landfester, Chemical Society Reviews 2018, 47, 23 8572.

[41] T. J. Lagny, P. Bassereau, Interface Focus 2015, 5, 4 20150038.

[42] R. Mau, J. Nazir, S. John, H. Seitz, Current Directions in Biomedical Engineering 2019, 5, 1 249.

[43] M. Malinauskas, P. Danilevicius, D. Baltriukiene, M. Rutkauskas, A. Žukauskas, Z. Kairyte, G. Bickauskaite, V. Purlys, D. Paipulas, V. Bukelskiene, R. Gadonas, Lithuanian Journal of Physics 2010, 50, 1 75.

[44] J. Cama, M. Schaich, K. A. Nahas, S. Hernandez-Ainsa, S. Pagliara, U. F. Keyser, Scientific Reports 2016, 6, 1.

[45] P. K. Gasbjerg, P. A. Knauf, J. Brahm, Journal of General Physiology 1996, 108, 6 565.

[46] H. Sauer, V. Pütz, K. Fischer, J. Hescheler, M. Wartenberg, British Journal of Cancer 1999, 80, 8 1204.

[47] H. Ko, M. C. Ratri, K. Kim, Y. Jung, G. Tae, K. Shin, Scientific Reports 2020, 10, 1.

[48] R. Wood, F. Wirth, H. Morgan, Biochimica et Biophysica Acta (BBA)-Biomembranes 1968, 163, 2 171.

[1-1] Cama, J.; Chimerel, C.; Pagliara, S.; Javer, A.; Keyser, U. F. A label-free microfluidic assay to quantitatively study antibiotic diffusion through lipid membranes. Lab Chip 2014, 14, 2303-2308.

[1-2] Weiss, M. et al. Sequential bottom-up assembly of mechanically stabilized synthetic cells by microfluidics. Nature Materials 2017, 17, 89-96.

[1-3] Soumpasis, D. Theoretical analysis of fluorescence photobleaching recovery experiments. Biophysical Journal 1983, 41, 95-97.

[1-4] Axelrod, D.; Koppel, D.; Schlessinger, J.; Elson, E.; Webb, W. Mobility measurement by analysis of fluorescence photobleaching recovery kinetics. Biophysical Journal 1976, 16, 1055-1069.

[1-5] Chinga, G.; Johnsen, P. O.; Dougherty, R.; Berli, E. L.; Walter, J. Quantification of the 3D microstructure of SC surfaces. Journal of Microscopy 2007, 227, 254-265.

The content of all references is incorporated by reference.

Reference signs

1    defined structure
2    compartment
3    lipid bilayer
4    porous structure
5    voxel
6    laser beam
7    focal point

**Claims**

1.  Method for non-invasive production of defined structures (1) inside compartments (2)
    wherein the method comprises the steps of:

    (a) providing a compartment (2) having an inside filled with a liquid, comprising a photoresist, and
    (b) applying a light to the inside of the compartment (2) including the photoresist, wherein the light has a focal point (7) inside the compartment (2) and initiates a chemical reaction of the photoresist at the focal point (7), creating a defined structure (1).

2.  Method according to claim 1,
    wherein the compartment is a vesicle, preferably a multilamellar vesicle or a unilamellar vesicle, more preferably a GUV, a droplet, a coacervate, a synthetic cell, an organelle or a natural cell.

3.  Method according to claim 1 or 2,
    wherein the compartment is essentially round and has preferably a diameter in the range of 1 $\mu$m to 10.000 $\mu$m, more preferably 3 $\mu$m to 1000 $\mu$m, even more preferably 5 $\mu$m to 500 $\mu$m, most preferably 10 $\mu$m to 200 $\mu$m.

4.  Method according to any one of the preceding claims,
    wherein the compartment has a compartment wall defining the inside and an outside, wherein the compartment wall comprises a surfactant stabilized fluid interface, wherein the surfactant is preferably a polymeric surfactant or a lipid.

5.  Method according to any one of the preceding claims,
    wherein the light is a laser beam, in particular a focused laser beam having its focal point inside the compartment.

6.  Method according to any one of the preceding claims,
    wherein during step (b) the focal point moves inside the compartment.

7.  Method according to any one of the preceding claims,
    wherein the compartment has a compartment wall defining the inside and an outside, wherein a wavelength of the light is selected so that the light can pass through the compartment wall and the focal point (7) can be inside the compartment.

8.  Method according to claim 7,
    wherein during step (b) the focal point moves across the compartment wall.

9.  Method according to any one of the preceding claims,

    wherein the photoresist is a negative resist, or
    wherein the photoresist is a positive resist.

10. Method according to any one of the preceding claims,
    wherein the photoresist is a negative resist and includes a monomer component and an initiator component, wherein the monomer has more than one polymerizable group.

11. Method according to any one of the preceding claims,
    wherein the concentration of the monomer in the liquid is in the range of 1 mg/ml to 500 mg/ml, preferably in the range of 5 mg/ml to 400 mg/ml, more preferably in the range of 10 mg/l to 300 mg/ml, even more preferably in the range of 50 mg/ml to 150 mg/ml.

12. Method according to any one of the preceding claims,
    wherein the concentration of the photopolymerization initiator in the liquid is in the range of 0.5 mg/ml to 200 mg/ml, preferably in the range of 1 mg/ml to 100 mg/ml, more preferably in the range of 5 mg/l to 50 mg/ml, even more preferably in the range of 10 mg/ml to 30 mg/ml.

13. Method according to any one of the preceding claims,
    wherein the chemical reaction initiated in step (b) is initiated by a two-photon absorption.

14. Method according to any one of the preceding claims,
    wherein the photoresist includes a photoinitiator, wherein the photoinitiator is preferably a two-photon initiator, such as a radical photopolymerization initiator.

15. Compartment (2), having an inside, surrounded by a compartment wall, wherein the compartment (2) comprises a defined structure (1) obtainable by a method according to any one of the preceding claims.

16. Compartment according to claim 15,
    wherein the structure (1) is a pore or a porous structure, preferably extending through the compartment wall.

EP 4 160 313 A1

**Fig. 1**

**Fig. 2**

21

**Fig. 3**

**Fig. 4**

**Fig. 5**

**Fig. 6**

**Fig. 7**

**Fig. 8**

**Fig. 9**

**Fig. 10**

**Fig. 11**

**Fig. 12**

**Fig. 13**

**Fig. 14**

**Fig. 15**

Fig. 16

Fig. 17

**Fig. 18**

Europäisches
Patentamt

European
Patent Office

Office européen
des brevets

# EUROPEAN SEARCH REPORT

**Application Number**

EP 21 20 0214

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 11 084 718 B2 (MAX PLANCK GESELLSCHAFT [DE]) 10 August 2021 (2021-08-10) | 1,3, 5-14,16 | INV. G03F7/20 |
| Y | * column 2, lines 17-41 * | 7,8 | G03F7/00 |
| A | * column 4, lines 34-53 * | 2,4 | B33Y10/00 |
| | * column 6, lines 33-45 * | | |
| | * column 7, lines 55-67 * | | |
| | ----- | | |
| X | US 2014/030655 A1 (DEVOE ROBERT J [US]) 30 January 2014 (2014-01-30) | 1,3,5-15 | |
| Y | * paragraphs [0068], [0069]; figure 1 * | 7,8 | |
| | ----- | | |
| X | US 9 910 352 B2 (DOYLE PATRICK SEAMUS [US]; PREGIBON DANIEL COLIN [US] ET AL.) 6 March 2018 (2018-03-06) * column 8, line 53 – line 67; figures 1a,1b,2,5,6a-e, * * column 9, line 55 – column 10, line 6 * * column 12, lines 1-18; figures 3o-p * | 1,3,6,7, 9,10, 13-16 | |
| | ----- | | |
| A | US 2014/031285 A1 (ANSETH KRISTI S [US] ET AL) 30 January 2014 (2014-01-30) * paragraphs [0026] – [0028], [0032], [0081], [0082], [0086] – [0090], [0095], [0101] – [0105]; figures 7-9 * | 1-16 | TECHNICAL FIELDS SEARCHED (IPC) G03F B33Y A61K |
| | ----- | | |
| A | STÉPHANIE DESHAYES ET AL: "Polymeric biomaterials with engineered degradation", JOURNAL OF POLYMER SCIENCE PART A: POLYMER CHEMISTRY, vol. 51, no. 17, 22 June 2013 (2013-06-22) , pages 3531-3566, XP055234988, US ISSN: 0887-624X, DOI: 10.1002/pola.26765 * page 3550 – page 3555; figure 1518 * | 1-16 | |
| | ----- | | |
| A | US 2021/031441 A1 (FUJITA KATSUMASA [JP] ET AL) 4 February 2021 (2021-02-04) * paragraphs [0061] – [0079]; figure 1 * | 1-16 | |
| | ----- | | |
| | -/-- | | |

The present search report has been drawn up for all claims

| Place of search | Date of completion of the search | Examiner |
|---|---|---|
| Munich | 10 March 2022 | Loughman, John |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

**EP 21 20 0214**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2020/170949 A1 (SPATZ JOACHIM P [DE] ET AL) 4 June 2020 (2020-06-04) * paragraphs [0001], [0002], [0007], [0029] – [0031], [0033]; figures 1,3 * ----- | 2 | |
| A | US 2005/196702 A1 (BRYANT STEPHANIE J [US] ET AL) 8 September 2005 (2005-09-08) * paragraphs [0003], [0007], [0014] – [0016], [0018], [0027], [0034], [0042], [0045], [0049], [0001]; figures 1a–1c * ----- | 1–16 | |

TECHNICAL FIELDS
SEARCHED      (IPC)

The present search report has been drawn up for all claims

| Place of search | Date of completion of the search | Examiner |
|---|---|---|
| Munich | 10 March 2022 | Loughman, John |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
............................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 20 0214

This annex lists the patent family members relating to the patent documents cited in the above-mentioned European search report.
The members are as contained in the European Patent Office EDP file on
The European Patent Office is in no way liable for these particulars which are merely given for the purpose of information.

10-03-2022

| Patent document cited in search report | | Publication date | Patent family member(s) | | Publication date |
|---|---|---|---|---|---|
| US 11084718 | B2 | 10-08-2021 | EP | 3306394 A1 | 11-04-2018 |
| | | | US | 2018099869 A1 | 12-04-2018 |
| US 2014030655 | A1 | 30-01-2014 | CN | 103492951 A | 01-01-2014 |
| | | | EP | 2699965 A2 | 26-02-2014 |
| | | | JP | 2014517856 A | 24-07-2014 |
| | | | US | 2014030655 A1 | 30-01-2014 |
| | | | WO | 2012145282 A2 | 26-10-2012 |
| US 9910352 | B2 | 06-03-2018 | US | 2007105972 A1 | 10-05-2007 |
| | | | US | 2010172898 A1 | 08-07-2010 |
| | | | US | 2015234270 A1 | 20-08-2015 |
| US 2014031285 | A1 | 30-01-2014 | NONE | | |
| US 2021031441 | A1 | 04-02-2021 | EP | 3750688 A1 | 16-12-2020 |
| | | | JP | WO2019155933 A1 | 11-03-2021 |
| | | | US | 2021031441 A1 | 04-02-2021 |
| | | | WO | 2019155933 A1 | 15-08-2019 |
| US 2020170949 | A1 | 04-06-2020 | CN | 110753539 A | 04-02-2020 |
| | | | EP | 3415140 A1 | 19-12-2018 |
| | | | EP | 3630068 A1 | 08-04-2020 |
| | | | JP | 2020523320 A | 06-08-2020 |
| | | | US | 2020170949 A1 | 04-06-2020 |
| | | | WO | 2018228894 A1 | 20-12-2018 |
| US 2005196702 | A1 | 08-09-2005 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JUÁREZ et al.** *Front. Bioeng. Bio-technol., http://dx.doi.org/10.3389/fbioe.2014.00026*
- *J. Org. Chem.,* 1988, vol. 53, 1966-1969, https://doi.org/10.1021/jo00244a022
- **BENGAL.** *Small,* 2020, vol. 16, 1906259, https://doi.org/10.1002/smll.201906259
- **KUMAR ; LIN.** *Chem. Rev.,* 2021, vol. 121 (12), 6991-7031
- **FURUTANI et al.** *Polymer International,* vol. 68 (1), 79-82, https://doi.org/10.1002/pi.5696
- **KASAHARA et al.** Photolithographic shape control of DNA hydrogels by photo-activated self-assembly of DNA nanostructures. *APL Bioengineering,* 2020, vol. 4, 016109, https://doi.org/10.1063/1.5132929
- **H. MUTSCHLER ; T. ROBINSON ; T.-Y. D. TANG ; S. WEGNER.** *ChemBioChem,* 2019, vol. 20, 20-2533
- **K. GÖPFRICH ; I. PLATZMAN ; J. P. SPATZ.** *Trends in Biotechnology,* 2018, vol. 36, 9-938
- **P. SCHWILLE ; J. SPATZ ; K. LANDFESTER ; E. BODENSCHATZ ; S. HERMINGHAUS ; V. SOURJIK ; T. J. ERB ; P. BASTIAENS ; R. LIPOWSKY ; A. HYMAN.** *Angewandte Chemie International Edition,* 2018, vol. 57, 41-13382
- **K. GÖPFRICH ; B. HALLER ; O. STAUFER ; Y. DREHER ; U. MERSDORF ; I. PLATZMAN ; J. P. SPATZ.** *ACS Synthetic Biology,* 2019, vol. 8, 5-937
- **M. WEISS ; J. P. FROHNMAYER ; L. T. BENK ; B. HALLER ; J.-W. JANIESCH ; T. HEITKAMP ; M. BÖRSCH ; R. B. LIRA ; R. DIMOVA ; R. LIPOWSKY.** *Nature Materials,* 2017, vol. 17, 1-89
- **L. V. DE CAUTER ; F. FANALISTA ; L. VAN BUREN ; N. D. FRANCESCHI ; E. GODINO ; S. BOUW ; C. DANELON ; C. DEKKER ; G. H. KOENDERINK ; K. A. GANZINGER.** *ACS Synthetic Biology,* 2021, vol. 10, 7-1690
- **S. DESHPANDE ; Y. CASPI ; A. E. C. MEIJERING ; C. DEKKER.** *Nature Communications,* 2016, vol. 7, 1
- **B. C. BUDDINGH ; J. C. M. VAN HEST.** *Accounts of Chemical Research,* 2017, vol. 50, 4-769
- **M. I. ANGELOVA ; D. S. DIMITROV.** *Faraday Discussions of the Chemical Society,* 1986, 81-303

- **K. KURIHARA ; M. TAMURA ; K. ICHIROH SHOHDA ; T. TOYOTA ; K. SUZUKI ; T. SUGAWARA.** *Nature Chemistry,* 2011, vol. 3, 10-775
- **K. Y. LEE ; S.-J. PARK ; K. A. LEE ; S.-H. KIM ; H. KIM ; Y. MEROZ ; L. MAHADEVAN ; K.-H. JUNG ; T. K. AHN ; K. K. PARKER.** *Nature Biotechnology,* 2018, vol. 36, 6-530
- **T. POLS ; H. R. SIKKEMA ; B. F. GAASTRA ; J. FRALLICCIARDI ; W. M. SMIGIEL ; S. SINGH ; B. POOLMAN.** *Nature Communications,* 2019, vol. 10, 1
- **S. KRISHNAN ; D. ZIEGLER ; V. ARNAUT ; T. G. MARTIN ; K. KAPSNER ; K. HENNEBERG ; A. R. BAUSCH ; H. DIETZ ; F. C. SIMMEL.** *Nature Communications,* 2016, vol. 7, 1
- **A. OHMANN ; K. GÖPFRICH ; H. JOSHI ; R. F. THOMPSON ; D. SOBOTA ; N. A. RANSON ; A. AKSIMENTIEV ; U. F. KEYSER.** *Nucleic Acids Research,* 2019, vol. 47, 21-11441
- **L. PASOTTI ; N. POLITI ; S. ZUCCA ; M. G. C. D. ANGELIS ; P. MAGNI.** *PLoS ONE,* 2012, vol. 7, 7-e39407
- **A. JESORKA ; N. STEPANYANTS ; H. ZHANG ; B. ORTMEN ; B. HAKONEN ; O. ORWAR.** *Nature Protocols,* 2011, vol. 6, 6-791
- **Y. DREHER ; K. JAHNKE ; E. BOBKOVA ; J. P. SPATZ ; K. G..OPFRICH.** *Angewandte Chemie International Edition,* 2021, vol. 60, 19-10661
- **Y.-H. M. CHAN ; B. VAN LENGERICH ; S. G. BOXER.** *Proceedings of the National Academy of Sciences,* 2009, vol. 106, 4-979
- **S. DESHPANDE ; S. WUNNAVA ; D. HUETING ; C. DEKKER.** *Small,* 2019, vol. 15, 38-1902898
- **R. B. LIRA ; T. ROBINSON ; R. DIMOVA ; K. A. RISKE.** *Biophysical Journal,* 2019, vol. 116, 1-79
- **S. DESHPANDE ; F. BRANDENBURG ; A. LAU ; M. G. F. LAST ; W. K. SPOELSTRA ; L. REESE ; S. WUNNAVA ; M. DOGTEROM ; C. DEKKER.** *Nature Communications,* 2019, vol. 10, 1
- **N. YANDRAPALLI ; J. PETIT ; O. BÄUMCHEN ; T. ROBINSON.** *Communications Chemistry,* 2021, vol. 4, 1
- **J. W. HINDLEY ; Y. ELANI ; C. M. MCGILVERY ; S. ALI ; C. L. BEVAN ; R. V. LAW ; O. CES.** *Nature Communications,* 2018, vol. 9, 1

- **M. J. BOOTH ; V. R. SCHILD ; A. D. GRAHAM ; S. N. OLOF ; H. BAYLEY.** *Science Advances,* 2016, vol. 2, 4-e1600056
- **E. H. REED ; B. S. SCHUSTER ; M. C. GOOD ; D. A. HAMMER.** *ACS Synthetic Biology,* 2020, vol. 9, 3-500
- **C. CHOU ; D. YOUNG ; A. DEITERS.** *Angewandte Chemie International Edition,* 2009, vol. 48, 32-5950
- **K. JAHNKE ; M. WEISS ; C. WEBER ; I. PLATZMAN ; K. GÖPFRICH ; J. P. SPATZ.** *Advanced Biosystems,* 2020, vol. 4, 9-2000102
- **K. JAHNKE ; N. RITZMANN ; J. FICHTLER ; A. NITSCHKE ; Y. DREHER ; T. ABELE ; G. HOF-HAUS ; I. PLATZMAN ; R. R. SCHRODER ; D. J. MULLER.** *Nature Communications,* 2021, vol. 12, 1
- **J.-C. LIN ; C.-Y. CHIEN ; C.-L. LIN ; B.-Y. YAO ; Y.-I. CHEN ; Y.-H. LIU ; Z.-S. FANG ; J.-Y. CHEN ; W. YA CHEN ; N.-N. LEE.** *Nature Communications,* 2019, vol. 10, 1
- **C. CAMPILLO ; B. P'EPIN-DONAT ; A. VIALLAT.** *Soft Matter,* 2007, vol. 3, 11-1421
- **S. MARUO ; O. NAKAMURA ; S. KAWATA.** *Optics Letters,* 1997, vol. 22, 2-132
- **X. ZHENG ; J. DEOTTE ; M. P. ALONSO ; G. R. FARQUAR ; T. H. WEISGRABER ; S. GEM-BERLING ; H. LEE ; N. FANG ; C. M. SPA-DACCINI.** *Review of Scientific Instruments,* 2012, vol. 83, 12-125001
- **V. HAHN ; P. KIEFER ; T. FRENZEL ; J. QU ; E. BLASCO ; C. BARNER-KOWOLLIK ; M. WEGEN-ER.** *Advanced Functional Materials,* 2020, vol. 30, 26-1907795
- **M. HIPPLER ; E. BLASCO ; J. QU ; M. TANAKA ; C. BARNER-KOWOLLIK ; M. WEGENER ; M. BASTMEYER.** *Nature Communications,* 2019, vol. 10, 1
- **D. JIN ; Q. CHEN ; T.-Y. HUANG ; J. HUANG ; L. ZHANG ; H. DUAN.** *Materials Today,* 2020, vol. 32, 19
- **J. SONG ; C. MICHAS ; C. S. CHEN ; A. E. WHITE ; M. W. GRINSTAFF.** *Macromolecular Bioscience,* 2021, vol. 21, 5-2100051
- **W. ZHANG ; P. SOMAN ; K. MEGGS ; X. QU ; S. CHEN.** *Advanced Functional Materials,* 2013, vol. 23, 25-3226
- **S. ENGELHARDT ; E. HOCH ; K. BORCHERS ; W. MEYER ; H. KRÜGER ; G. E. M. TOVAR ; A. GILL-NER.** *Biofabrication,* 2011, vol. 3, 2-025003
- **R. DIMOVA.** *Annual Review of Biophysics,* 2019, vol. 48, 1-93
- **E. RIDEAU ; R. DIMOVA ; P. SCHWILLE ; F. R. WURM ; K. LANDFESTER.** *Chemical Society Reviews,* 2018, vol. 47, 23-8572
- **T. J. LAGNY ; P. BASSEREAU.** *Interface Focus,* 2015, vol. 5, 4-20150038
- **R. MAU ; J. NAZIR ; S. JOHN ; H. SEITZ.** *Current Directions in Biomedical Engineering,* 2019, vol. 5, 1-249
- **M. MALINAUSKAS ; P. DANILEVIČIUS ; D. BALTRIUKIENE ; M. RUTKAUSKAS ; A. ŽUKAUSKAS ; Z. KAIRYTE ; G. BIČKAUSKAITE ; V. PURLYS ; D. PAIPULAS ; V. BUKELSKIENE.** *Lithuanian Journal of Physics,* 2010, vol. 50, 1-75
- **J. CAMA ; M. SCHAICH ; K. A. NAHAS ; S. HERNANDEZ-AINSA ; S. PAGLIARA ; U. F. KEY-SER.** *Scientific Reports,* 2016, vol. 6, 1
- **P. K. GASBJERG ; P. A. KNAUF ; J. BRAHM.** *Journal of General Physiology,* 1996, vol. 108, 6-565
- **H. SAUER ; V. PÜTZ ; K. FISCHER ; J. HESCHELER ; M. WARTENBERG.** *British Journal of Cancer,* 1999, vol. 80, 8-1204
- **H. KO ; M. C. RATRI ; K. KIM ; Y. JUNG ; G. TAE ; K. SHIN.** *Scientific Reports,* 2020, vol. 10, 1
- **R. WOOD ; F. WIRTH ; H. MORGAN.** *Biochimica et Biophysica Acta (BBA)-Biomembranes,* 1968, vol. 163, 2-171
- **CAMA, J. ; CHIMEREL, C. ; PAGLIARA, S. ; JAV-ER, A. ; KEYSER, U. F.** A label-free microfluidic assay to quantitatively study antibiotic diffusion through lipid membranes. *Lab Chip,* 2014, vol. 14, 2303-2308
- **WEISS, M. et al.** Sequential bottom-up assembly of mechanically stabilized synthetic cells by microfluidics. *Nature Materials,* 2017, vol. 17, 89-96
- **SOUMPASIS, D.** Theoretical analysis of fluorescence photobleaching recovery experiments. *Biophysical Journal,* 1983, vol. 41, 95-97
- **AXELROD, D. ; KOPPEL, D. ; SCHLESSINGER, J. ; ELSON, E. ; WEBB, W.** Mobility measurement by analysis of fluorescence photobleaching recovery kinetics. *Biophysical Journal,* 1976, vol. 16, 1055-1069
- **CHINGA, G. ; JOHNSEN, P. O. ; DOUGHERTY, R. ; BERLI, E. L. ; WALTER, J.** Quantification of the 3D microstructure of SC surfaces. *Journal of Microscopy,* 2007, vol. 227, 254-265